# EUROPEAN PATENT SPECIFICATION

(11) **EP 1 352 258 B1**
(45) Date of publication and mention of the grant of the patent: **11.03.2009**
(21) Application number: 02729460.2
(22) Date of filing: 11.01.2002
(51) Int. Cl.: G01R 33/38, G01R 33/48, G01V 3/32

(54) **MAGNETIC FIELD GENERATING ASSEMBLY AND METHOD**
VERFAHREN UND VORRICHTUNG ZUR ERZEUGUNG EINES MAGNETFELDES
ENSEMBLE GENERATEUR DE CHAMP MAGNETIQUE ET PROCEDE

(30) Priority: 12.01.2001 GB 0100900; 17.12.2001 GB 0130121
(43) Date of publication of application: 15.10.2003
(73) Proprietor: Oxford Instruments Superconductivity Limited, Witney, Oxon OX8 1TL (GB)
(72) Inventor: SLADE, Robert Andrew, Witney, Oxon OX29 4AX (GB); HAWKES, Robert Carter, Dry Drayton, Cambridge CB3 8BU (GB); LUCAS, Alun J., Royston, Hertfordshire SG8 7TU (GB); MCDOUGALL, Ian Leitch, Oxon OX8 3EL (GB)
(74) Representative: Skone James, Robert Edmund
(86) International application number: PCT/GB2002/000111
(87) International publication number: WO 2002/056047

(56) References cited:
- EP-A- 0 512 345
- US-A- 4 710 713
- US-A- 5 296 811
- US-A- 5 432 446
- US-A- 5 488 342
- US-A- 5 677 630
- US-A- 5 835 995
- US-A- 5 936 404

## Description

The invention relates to magnetic field generating assemblies and methods for use in magnetic resonance and in particular to "inside-out". Nuclear Magnetic Resonance (NMR or MR) instrumentation for use in non-invasive investigation of material properties. These have applications in a wide variety of fields, such well logging, medical MR Imaging (MRI) and NMR Spectroscopy (NMRS or MRS).

"Inside-out Lift", "external field NMR", "remotely positioned MR", "projected field MR", "one-sided MR" and "maximum access MR" are all terms used to describe instruments which perform NMR measurements on objects or subjects placed outside the physical envelope of the measuring apparatus. The distinction is clear when such systems are compared with conventional NMR spectroscopy or MRI systems, in which the sample to be investigated is placed inside the apparatus, typically in the bore of a superconducting solenoid magnet. Whilst the conventional approach is generally preferable in terms of cost effective generation of the strong and uniform static magnetic field required for NMR measurements, the particular circumstances of some applications demand an in-situ measurement, which can only be achieved with a remotely-positioned instrument.

For clarity the "inside-out NMR" apparatus will be termed an "external field" -system; in comparison, conventional apparatus, in which the sample is placed inside the space envelope of the magnet, will be termed "internal field" systems.

A good example of an application which requires an external field NMR instrument is the NMR well logging tool. Properties of interest in NMR well logging are overall signal intensity (which is proportional to proton density) and the distribution of the bulk relaxation time constants T1 and T2 (which are manifested in the time-dependence of the NMR signals) .

Early tools such as Schlumberger's Nuclear Magnetic Logging (NML) tool, as described by US-A-3213357, in "An improved NMR logging system and its Applications to Formation Evaluation", Herrick, R. C. et al, SPE 8361, 54th Annual Fall Technical Conference of the Society of Petroleum Engineers of AIME, Las Vagas, Sept. 23-26, 1979, and US-A-3667035 used pulsed electromagnets and the Earth's magnetic field to generate NMR signals from earth formations in-situ.

Systems using permanent magnets to generate the static magnetic field later gained favour over electromagnet systems. The most notable permanent magnet systems are those described in US-A-4350955, US-A-4710713 and US-A-4933638. The latter two systems have been commercialised as Numar's MRIL^{™} and Schlumberger's CMR^{™}. However, neither of these tools is available in diameters smaller than about 5.5 inches (14cm), which limits their use to larger holes. The reason is that the performance of existing tool designs suffers considerably as the diameter is reduced, The fundamental reasons behind this problem are explained in the following discussion of the physics of NMR well logging.

The volume available for the permanent magnet material is clearly limited by the tool diameter. Adding magnet material spaced axially along the tool away from the sensitive volume (SV) eventually becomes of limited use as the separation of new material from the SV increases. Smaller diameter tools therefore have to make do with less stored magnetic energy to generate the magnetic field in the SV.

The designer of an external-field NMR instrument must ensure that an adequate level of NMR signal is generated within the SV to enable a sufficiently accurate measurement to be made in a suitable time interval. The total NMR signal strength is related to the size of the SV, the degree of magnetization of the sample, the receiver efficiency, and the density of resonant nuclear spins within the SV. The first three are determined by the tool design, whilst the last is part of the bulk NMR information measured.

Assuming sufficient time is left for full spin-lattice (T1) relaxation before measurement, the magnetization of the sample is directly proportional to the magnetic field strength (or flux density, BO) in the SV. As will be clear to those versed in the art the size of the SV is in turn limited by the magnetic field inhomogeneity and the bandwidth of the transmitted RF - the SV will increase in a more uniform field and with larger RF bandwidth. A downhole tool is always operated with the maximum possible RF bandwidth allowed by available peak RF pulse power. Therefore to maximise the SV the designer seeks to increase field homogeneity. Unfortunately, if the stored magnetic energy is held constant improvements in homogeneity achieved by adjusting the magnet geometry can only be achieved at the expense of field strength.

Selection of the minimum field homogeneity is also governed by other considerations. For example the allowed field inhomogeneity in the SV of a well logging instrument is typically very much greater than that feasible for an MRI or spectroscopy magnet (eg: 20000 parts-per-million (ppm) compared to 50ppm or less in the latter). This is because the well logging tool only measures bulk NMR properties and a multi-pulse sequence may be used to reverse phase dispersion caused by magnetic field inhomogeneity. Typically the CPMG pulse sequence (Meiboom et al, "modified spin-echo method for measuring nuclear relaxation times", Rev. Sci. Instrum. 29, 688-691, 1958) is used: a series of NMR "spin-echo" signals are generated by the application of a carefully timed sequence of radio-frequency (RF) oscillating magnetic field pulses, and the spin density and T1 and T2 parameters are derived from the echo train data.

MRI requires field homogeneity of the order 50ppm or better (and good gradient linearity) to avoid unacceptable distortion of the image. Modified versions of CMPG, such as RARE, HASTE and SPARE, may be used in specialised MRI to tolerate higher field inhomogeneity, with care exercised to avoid RF heating of the sample.

Assuming a CPMG-like sequence is used, the limitation on maximum allowable field inhomogeneity in a well logging tool is therefore defined by the available RF bandwidth and the size of sensitive volume required to generate the necessary NMR signal level. With the RF bandwidth set to the maximum allowed by available pulse power, maximising the size of the SV relies on reducing the field inhomogeneity without compromising field strength, which presents a problem as previously mentioned. All magnetic fields obey Maxwell's Divergence theorem, and therefore cannot be completely uniform within a three-dimensional volume of space that is not completely enclosed by the field generating means. In a conventional internal-field NMR instrument the designer takes advantage of the fact that the strongest and most uniform field is naturally generated inside the magnet structure, whether this is inside a solenoid or between the poles of a C-magnet, for example. This option is not available with an external-field machine. The field gradients are much higher outside the apparatus, but they can be reduced by arranging the magnet geometry to cancel out the worst gradients. Unfortunately this also unavoidably reduces the field intensity in an external-field device. Examples of the magnet design process are illustrated in US-A-4701736 and US-A-5471140, US-A-5488342 and US-A-5646528. The designer therefore has to choose a suitable trade-off between magnetic field homogeneity and intensity for the available stored energy.

In summary, space, power and material restrictions limit the designer to generating the magnetic field using either an electromagnet with a given number of amp-turns, or a finite volume of permanent magnetic material of known remanence, or a combination of the two. Both magnetic field generating methods are characterised by a practical limit on the magnetic energy stored in the magnetic circuit. Therefore it is clear that to maximise the NMR signal the designer has to choose a magnet circuit (ie: magnet geometry) that achieves a satisfactory trade-off between field intensity and the size of the SV, which in turn is defined by the pulse bandwidth and the BO field inhomogeneity, the former of which must be maximised and the latter minimised.

Further examples of the useful applications of inside-out NMR are in the field of extremely open-access MR imaging as described in US-A-4689591, US-A-4701736, US-A-5023554, US-A-5117188, US-A-5744960, US-A-5959454, EP-A-0512345. In general these systems have not been implemented due to inadequate imaging performance or the cost involved in overcoming other technical difficulties. Specifically, it proves very difficult to provide an external magnetic field with properties comparable to that of a whole body solenoid system or C-magnet.

In comparison to bulk NMR measurements, the variation of the NMR signal properties across the measurement volume are used to create an image. The NMR signals are spatially encoded in the frequency-phase domain ("k-space") using user-applied pulsed magnetic field gradients and the image is reconstructed from the bulk NMR signal by Fourier Transformation. MRI is the established imaging method of choice for many types of clinical diagnosis.

These open access systems can be used by clinicians or surgeons seeking to carry out diagnostic, surgical or therapeutic tasks during the imaging process; these procedures are referred to collectively as Interventional MRI. I-MRI allows many operations to be carried out with minimum trauma, such as image guided biopsy and minimally invasive surgery. Finally there is increasing interest in taking MR images of the musculo-skeletal system under load (i.e.: with the patient sitting, standing or exercising). All of these MR imaging applications would benefit from more open access than that available from a solenoid or C-magnet.

In addition to these advantages, further less apparent advantages are achieved. An example is the ability to exploit the so-called "magic angle effect". Certain body tissues exhibit strong anisotropy in terms of their NMR response: the long-chain molecules in collagen are aligned along tendons and ligaments. When these organs are aligned at the "magic angle" of 55 degrees to the B0 field direction they generate a strong NMR signal. At other angles they generate little or no signal ("Orientation of tendons in the magnetic field and its effect on T2 relaxation times", Fullerton et al, Radiology, 1985; 2:433-435). It is advantageous to collect this signal as it may contain information of diagnostic value. However, the restrictive nature of conventional whole body machines, even the current generation of C-magnet open access machines, means that it is either very difficult or uncomfortable, or often physically impossible for the patient to achieve a posture that orients the tendon or ligament of interest at the magic angle to the BO magnetic flux direction. The even more limited access of many dedicated orthopaedic or extremity imaging systems is similarly preclusive. The extremely open access designs presented here solve this problem and allow magic angle imaging.

As a consequence of their open geometry and Maxwell's Divergence Theory all external-field NMR magnets are characterised by having reduced static magnetic field flux density with poor homogeneity in the measurement volume when compared to an internal-field NMR instrument having similar stored magnetic energy. The designer of an external-field system is therefore faced with a difficult optimisation problem: to balance many conflicting performance requirements, such as providing adequate NMR signal strength, with acceptable power consumption, suitably uniform signal distribution across the sample, and practical construction, all at acceptable cost.

By way of demonstrating the limitations of prior art extremely open-access MRI systems, let us compare the energy stored in the magnetic field of a conventional whole body solenoid with that in an equivalent flat magnet. In the case of down-hole tools the stored energy available is limited by the space constraints (in the case of permanent magnets) or power constraints (in the case of electromagnets). In the laboratory or medical environment these constraints are largely removed and systems with much higher stored magnetic energy can be utilised. The new limits therefore become the practical engineering design considerations such as magnetic forces, hoop-stress in windings, "quench" (reversion to resistive state) energy management, and of course, cost. However, stored magnetic energy is still a useful "rule of thumb" measure of the engineering difficulty and likely cost of a superconducting magnet.

Consider a solenoid magnet with a bore diameter of 1m and axial length of 2m, and a field strength of 0.5T having about 50 parts-per-million (ppm) variation over a 40cm diameter spherical volume (DSV) situated at the magnet isocentre; these are typical values for a commercial machine. This solenoid stores about 0.2MJ of energy. A flat magnet designed according to the methods of US-A-4701736 has overall diameter 3m, a field strength of 0.5T and a 14cm DSV with the same homogeneity and field strength as the solenoid, centred at a distance offset 21cm from the face of the magnet. The flat magnet stores 20MJ - 100 times as much as the solenoid. This is the price paid for open access.

Such problems as magnet stresses and quench energy management can be eased by operating at a lower magnetic field strength. Unfortunately, without making other changes this leads to a reduction in signal-to-noise ratio, caused principally by a reduction in the NMR signal strength, and an increase in 1/f noise. As described in "The Intrinsic Signal-to-Noise Ratio in NMR Imaging", Edelstein, W. et al, Magnetic Resonance in Medicine, 3, 604-618, 1986, the signal-to-noise ratio (SNR) of an MRI measurement depends on many factors, but in general scales as the 7/5 power of B0 field strength at lower frequencies where the receiver antenna losses are significant, falling to a linear dependence at higher frequencies when antenna losses become insignificant. Open access magnets tend to operate at lower field strengths (0.2 to 0.5T) which is generally in the 7/5 region. Therefore any reduction in field strength has a very adverse effect on SNR.

US-A-5677630 discloses a planar MRI magnetic field generating assembly containing several superconducting coils to generate a magnetic field outside the assembly.

US-A-5936404 describes a magnetic field generating assembly comprising a first and a second magnetic field generator, wherein the first magnetic field generator is used for a pre-polarization. During subsequent acquisition of the MR data, only the second magnetic field generator is activated to generate a low but uniform magnetic field.

In accordance with one aspect of the present invention, a magnetic field generating assembly comprises a magnetic field generation system including first and second magnetic field generators for generating respective, static magnetic fields; and a control system; the magnetic field generation system being arranged to generate, in a first mode, a first, relatively strong static magnetic field in a working volume located outside the assembly, and to generate, in a second mode, a second, static magnetic field in the working volume, wherein the control system is arranged to control the second magnetic field generator such that in the first mode the two magnetic field generators generate magnetic fields in the same sense to generate the first relatively strong magnetic field in the working volume, and such that in the second mode the two magnetic field generators generate magnetic fields in opposite senses such that the resultant magnetic field in the working volume is weaker but more uniform than the relatively strong magnetic field to enable a magnetic resonance process on a sample in the working region to be performed.

In accordance with a second aspect of the present invention, a method for obtaining NMR information about a sample comprises:
(i) operating a magnetic field generating assembly including first and second magnetic field generators such that both generate magnetic fields in the same sense to apply a relatively strong, generally non-uniform static magnetic field in a working volume located outside the assembly and containing a sample, for a duration longer than the longest spin-lattice relaxation time of the material of interest in the sample to allow enhanced magnetization to build up in the sample;
(ii) operating the first and second magnetic field generators to generate magnetic fields in opposite senses to apply a weaker but much more uniform static magnetic field across said working volume, the change in static magnetic field occurring in a time shorter than the shortest spin-spin relaxation time of the material of interest in the sample, but longer than the Larmor period;
(iii) applying a suitable sequence of radio frequency pulses to generate NML signals;
(iv) detecting and recording the NMR signals; and
(v) processing the recorded data.

We have appreciated that the BO properties of high field intensity and high homogeneity are not required simultaneously by the MR measurement. In this technique the first magnetic field generator must be capable of providing a strong, yet not necessarily homogeneous, field to build up magnetization in the sample which is then switched to a weaker but more homogeneous field for read-out of the NMR data.

This invention eases the design constraints of external-field NMR systems by using the principle of pre-polarization. Pre-polarization recognises that NMR measurements only require a uniform magnetic field for the measurement or read-out phase. A much less uniform field can be used in the pre-polarization phase before measurements when the magnetization builds in the sample. This means that the magnet geometry can be temporarily reconfigured (either by moving permanent magnets or switching currents in electromagnets) to provide a pre-polarization field which is much stronger than the measurement field without requiring an increase in stored energy. Generating the strong pre-polarization field, which boosts NMR signal and improves performance, in this way is more cost effective than adding extra hardware.

This has also been discussed in Macovski, et al (US 5057776, US 5835995 and "Novel Approaches in Low Cost TRI", MRM 30:221-230, 1993) but Macovski use physically separate electromagnets for generating the pre-polarization and readout fields in conjunction with a conventional internal field system. Practical embodiments using electromagnets require that the pre-polarization coil surrounds or is placed in close proximity to the imaging region, to maximise gauss/amp efficiency. The current in one electromagnet is turned on to provide the pre-polarization field and then turned off for the read-out phase. The current in the other magnet is either on continuously, or switched on for the read-out phase. The electromagnets may be either resistive or superconducting. In summary, all examples given by Macovski relate to "internal .field" hardware and additional hardware is added to achieve the pre-polarization field.

The present invention has recognised that the pre-polarization approach enables extremely open access systems to be developed using substantially flat magnetic field generating assemblies with stored magnetic energy and image quality similar to whole body solenoids of the same field strength.

In well logging applications the magnetic field generators could comprise electromagnets, but preferably they comprise relatively re-positionable permanent magnets.

There appears to be only one instance of the use of the pre-polarization technique in the field of NMR well logging: Schlumberger's NML tool. In the NML tool the uniform field needed to make NML measurements was provided by the Earth's magnetic field, and the stronger but less uniform field needed for pre-magnetization was provided from a pulsed electromagnet. However, this system suffered from many disadvantages the high power consumed by an electromagnet generating the pre-magnetization field limited its applicability in the field; the tool was not sensitive to shorter T2 components, (due to the overload recovery characteristic of the sensitive receiver electronics after application of the pre-polarization pulse); and, ironically, the excellent homogeneity of the Earth's field, used as the measurement field for the NMR echo acquisition, afforded no spatial selectivity, so that intense NMR signal originated from the mud filling the borehole, which was of no interest, but which swamped the signal from the fluid in rock pores. To overcome the latter problem, the borehole mud had to be doped with paramagnetic ions to shorten the unwanted signal's decay time to less than the tool's pulse recovery period. A similar system is described in US-A-3667035.

There are a number of differences between the preferred well logging embodiments according to the invention and the prior art apparatus. For example, the preferred well logging embodiments of the present invention generate both the pre-polarization and measurement magnetic fields from their own permanent magnets, which has several advantages including improved SNR and control over the spatial location of the SV; they use spin-echo NMR measurements in place of free induction techniques allowing measurements to be made in relatively inhomogeneous static magnetic fields (typically several thousand parts per million); and finally they use permanent magnets in preference to electromagnets, for the following reasons. Resistive electromagnets use too much power - the electrical power that can be delivered to a wireline instrument several kilometres underground is severely limited by wireline cable dissipation. Superconducting magnets are impractical because the high-temperature down-hole environment generally renders the cryogenic systems needed to cool them thermodynamically impractical.

In MR applications, although the first magnetic field generator could comprise a permanent magnet, preferably it comprises an electromagnet while preferably also the second magnetic field generator comprises an electromagnet. When both comprise electromagnets, in the first mode of operation the current amplitude and direction in the second electromagnet is chosen so that the combined static magnetic field of the two magnets is strong but generally non-uniform across the working volume while in the second mode, the current amplitude and direction in the second electromagnet is chosen so that the combined field is weaker but more uniform. In some cases (but not according to the present invention) in the second mode of operation, the second magnetic field generator will generate no field. The embodiments of the present invention for MRI generally utilise superconducting electromagnets, however, for low-field/low-cost applications, iron-yoked resistive electromagnets or hybrid permanent and electromagnet systems may be more cost effective.

Preferably, the electromagnetic assembly is surrounded by a switched shield coil that is de-energised in the second but energised in the first mode so that it has magnetic moment substantially equal and opposite to the combined magnetic moment of the first and second magnetic field generators in the first mode. This reduces the external stray field.

Examples of apparatus and methods in accordance with the invention will now be described with reference to the accompanying drawings (which are not to scale), in which:-
Figures 1A-1C are a depiction of the CPMG NMR measurement sequence for use in a conventional well logging tool;
Figures 2A-2C are a depiction of the CPMG NMR measurement for a reduced diameter well logging tool without the method of the invention;
Figures 3A-3C are a depiction of a CPMG NMR measurement for a reduced diameter well logging tool with an example of the method of the invention;
Figure 4A shows a first embodiment of apparatus in the pre-magnetization state, shown in longitudinal section;
Figure 4B shows the same apparatus in the measurement state;
Figure 5A shows a second embodiment of apparatus in the pre-magnetization state, shown in longitudinal section;
Figure 5B shows the same apparatus in the measurement state, in transverse section across the centre plane, A-A;
Figure 5C shows the same apparatus in the measurement state, in longitudinal section;
Figure 6A shows a third embodiment of apparatus in the pre-magnetization state, shown in transverse section;
Figure 6B shows the same apparatus in the measurement state;
Figure 7A shows a fourth embodiment of apparatus in longitudinal section;
Figure 7B shows the same apparatus in transverse section across the centre plane B-B, in the pre-polarization state;
Figure 7C shows the same apparatus in transverse section across the centre plane B-B, in the measurement state;
Figures 8 and 9 show an example for an NMR surface investigator probe (which is not an embodiment of the present invention);
Figure 10 shows a plan view of the "butterfly" gradiometer antenna arrangement for the embodiment of Figures 8 and 9;
Figure 11 is a perspective view illustrating a sixth embodiment of the invention: a one-sided MR imaging magnet;
Figure 12 is a schematic cross-section of the one-sided MRI magnet, showing positions of the coils;
Figure 13 shows a field profile across a 20 x 20 cm slice in the YZ plane through the sensitive volume in read-out mode;
Figure 14 shows a field profile across the same 20 x 20 cm slice in the YZ plane through the sensitive volume in pre-polarization mode;
Figure 15 shows a field profile across a 20 x 20 cm slice in the XY plane through the sensitive volume in read-out mode;
Figure 16 illustrates a smaller scale one-sided magnet in a typical application for imaging of the spine;
Figure 17 is an example of a suitable circuit for a one-sided MRI magnet;
Figure 18 is a perspective view of one-sided RF antenna in the plane of the one-sided MRI magnet;
Figure 19 is a perspective view of pair of zero-coupling one-sided RF antennas in the plane of the one-sided MRI magnet;
Figure 20 is a perspective view of X axis gradient coil, in the plane of the one-sided MRI magnet;
Figure 21 is a perspective view of Y axis gradient coil in the plane of the one-sided MRI magnet;
Figure 22 is an example of a suitable spin-warp imaging pulse sequence using an applied Z-gradient for slice selection;
Figure 23 is an example of a suitable spin-warp imaging pulse sequence using the pre-polarization field gradient for slice-selection; and,
Figures 24 shows examples of simulated images of a "phantom" sample generated from the preferred embodiment of the one-sided MRI magnet with and without pre-polarization enhancement.

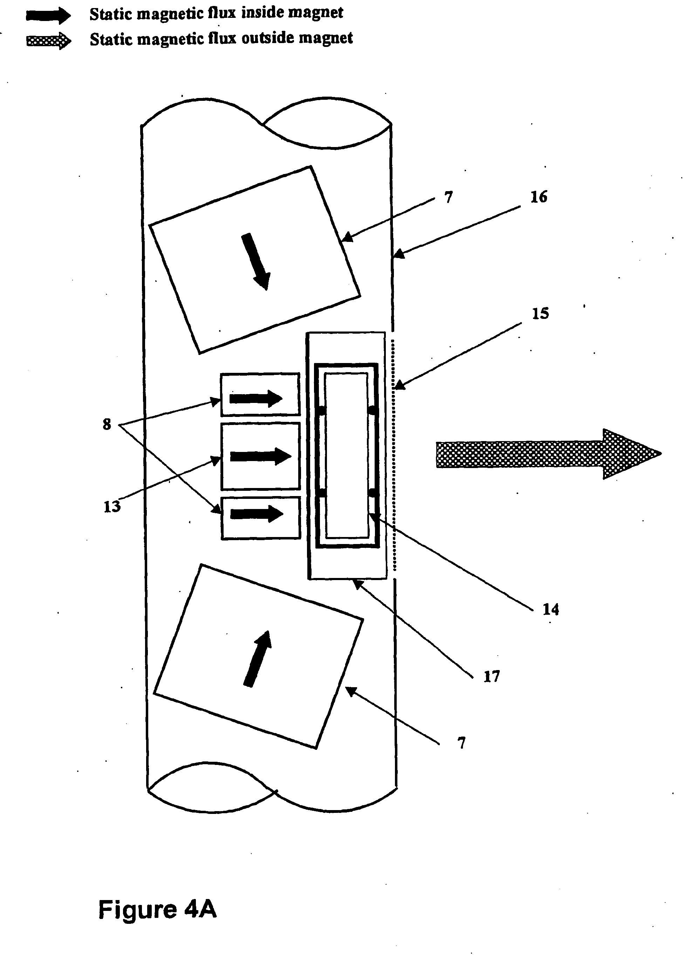

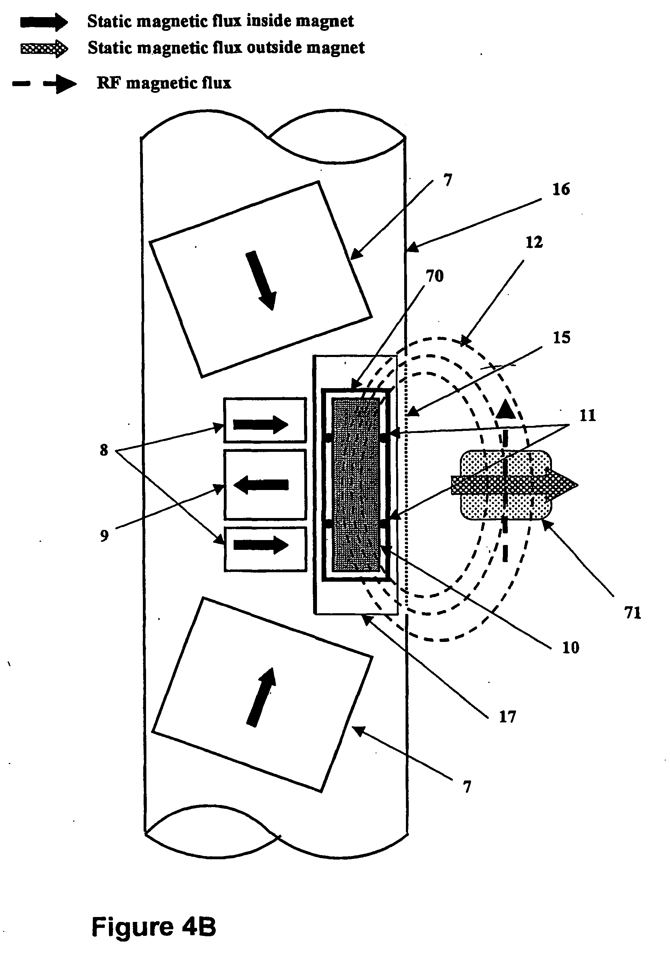

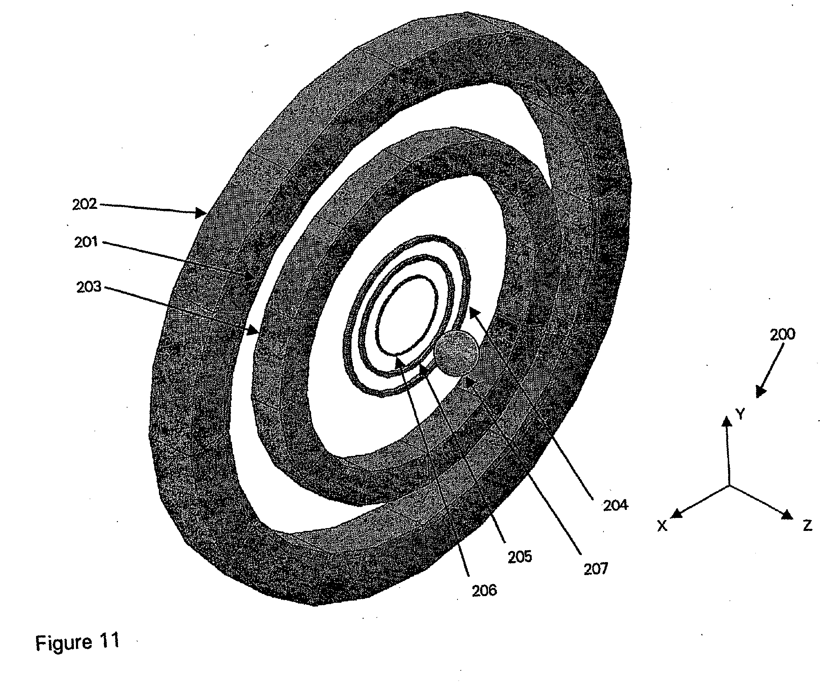

The present invention is particularly concerned with a method and apparatus to improve performance of external-field NMR instruments by pre-polarization. The first category of embodiments overcome the loss of NMR signal caused by scaling down NMR well logging tools to suit small hole diameters, (embodiments shown in Figures 4 to 8). The *second category of embodiments improve performance of one-sided extreme open-access MR imaging systems (embodiment shown in Figures 11 to 24).

The method involves switching the static field between two states: a strong, inhomogeneous "pre-magnetization" field that can be sustained for long enough to build the magnetization to an enhanced level, and a weaker, more uniform "read-out" field applied during the NMR measurement (i.e.: during the RF pulse sequence).

In the first category, the embodiments shown have a first state in which the limited stored magnetic energy is used to maximise the field intensity within the sensitive volume (without regard to field homogeneity, which consequently decreases) during the pre-magnetization period, and a second state in which the magnetic circuit is re-organised so that the same stored magnetic energy is used to optimise magnetic field homogeneity (without regard to field intensity, which consequently decreases) during the measurement pulse sequence. The two instrument states may be achieved using switched currents in electromagnets, but in the preferred embodiments in the first category, and in comparison to the prior art, they are implemented using mechanically re-positioned permanent magnets.

The preferred embodiments now described with reference to the figures are: in the first category, various slim-hole wireline logging tools featuring fixed and moveable permanent magnets; in the second category, as extremely open-access MR imaging system using a "flat" magnet with variable and fixed current superconducting HTS coils suitable for spine, brain and extremity imaging.

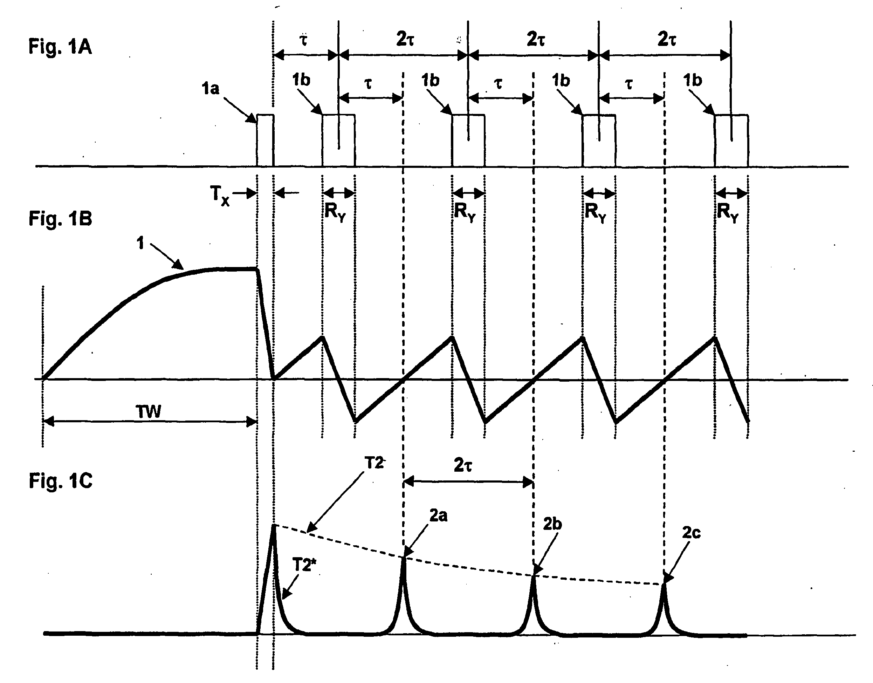

As previously described, the net result of the switched field pre-magnetization method is enhanced NMR signal. This is illustrated in Figures 1 to 3. Figure 1 schematically presents the evolution of magnetization during the application of a CPMG RF pulse sequence in a conventional NML well logging tool. As will be known to those skilled in the art, CPMG comprises an initial wait period, TW, during which magnetization builds up in the sample (1, Figure 1) as spin 1/2 nuclei (which have a magnetic moment) gradually align with the magnetic field with spin-lattice time constant T1. This pre-magnetization period is followed by a "tipping" RF pulse at the Larmor frequency (1a, Figure 1A), which effectively "tags" hydrogen nuclei in fluids within the rock pores where the local magnetic field is close to resonance, defining the SV. This is followed by a series of "re-focusing" RF pulses (1b), which reverse phase dispersion in the nuclear spin system of time constant T2* caused by magnetic field inhomogeneity, thus initiating subsequent momentary recreations of the initial magnetization equilibrium state and forming spin-echoes (2a, 2b, 2c, Figure 1C). The variation in spin-echo amplitudes over time depends on the spin-spin (T2) relaxation time constant of the sample, which is of interest. A full description of the use of the CPMG sequence in well logging tools is given in US-A-5023551.

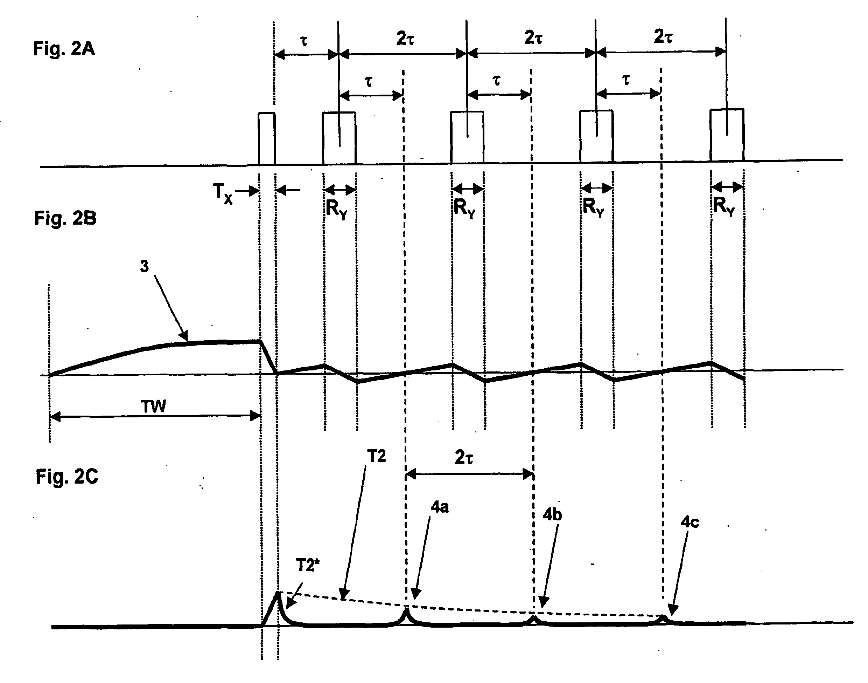

Figure 2 shows the same sequence applied to a reduced diameter version of the same apparatus. The precise magnet geometry is not important. The reduced instrument dimensions results in a smaller volume of Magnetic material, and hence the stored magnetic energy is reduced. Therefore to maintain the same volume in the SV (defined by the RF bandwidth and field homogeneity), the magnetic field is substantially weaker than in the full-size apparatus of Figure 1. This results in weaker magnetization (3, Figure 2B) and hence in a weaker NMR signal (smaller echoes, 4a, 4b, 4c, Figure 2C).

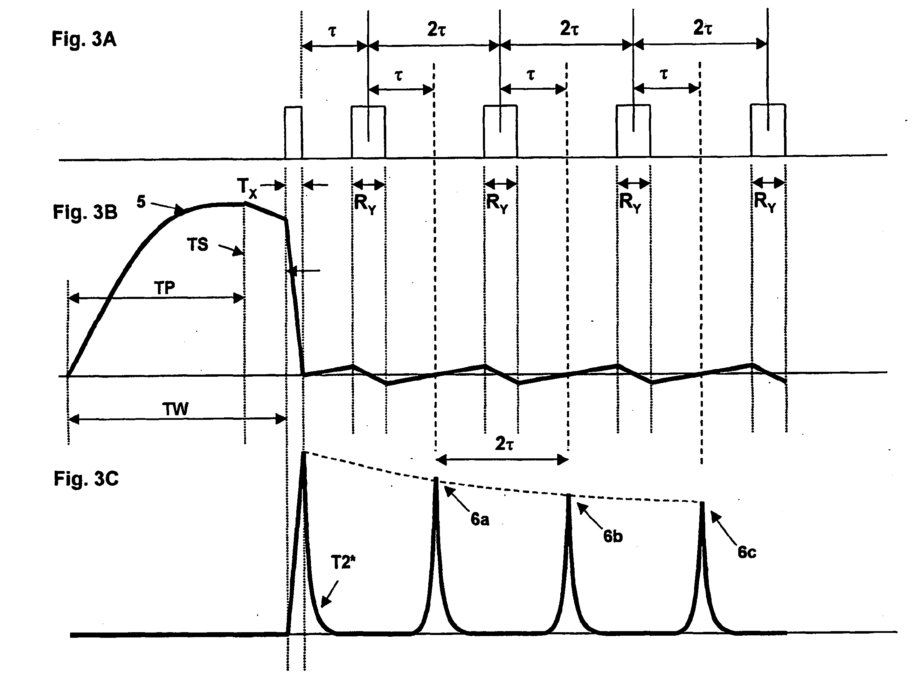

Figure 3 shows the same sequence applied to the reduced diameter apparatus of Figure 2, but in which the pre-polarization method of the invention has been used to maximise the magnetic field intensity and hence increase the sample magnetization during interval TP of the wait period TW, thus increasing the magnetization (5, Figure 3B) and largely restoring the NMR signal strength to that achieved with the full-scale apparatus (6a, 6b, 6c, Figure 3C).

Figures 1A, 2A and 3A show the timing of RF pulses; is half the inter-echo / inter-pulse period, T_{X} is the tipping pulse duration for a 90 degree tipping pulse, R_{Y} is the re-focusing pulse duration, typically 180 degrees in CPMG. The RF pulse subscripts X and Y denote the axis in the rotating frame along which the RF pulse acts, assuming the static field is oriented along Z, as will be familiar to those skilled in the art. Figures 1B, 2B and 3B show the evolution of the net longitudinal magnetization component (the component lying along the static magnetic field), and Figures 1C, 2C and 3C show the evolution of the net transverse magnetization component (the component lying perpendicular to the static magnetic field and contributing to the NMR signal), both summed over the sample volume.

In Figure 3C it can be seen that the echo amplitudes (6a-c) are enhanced compared to Figure 2C (4a-c). In the presence of the same level of stochastic noise it is apparent that the SNR will be improved.

An important consideration of this switched-field pre-polarization concept is the speed with which the field can be switched from one state to the other: this must be fast enough that the magnetization intensity built up during the pre-polarization phase does not have time to relax to the weaker field equilibrium value before measurement, yet not so fast that the field change induces resonance effects which would cause the magnetization to precess about the magnetic field, as it does after an RF pulse. The second condition is met if the field change occurs is an adiabatic fast passage (AFP), ie: faster than T1 but slower than the Larmor period.

It should be noted that the direction of the magnetic field during the pre-magnetization period is unimportant. The aim is merely to build up the maximum possible magnetization across the SV. However; when the field switches into the measuring state the magnetic field must be substantially orthogonal to the RF field, as usual. If the transition from one field state to the other is an AFP, then the magnetization direction will smoothly track the applied field without precessing, so that it will be aligned along the weaker measuring field at the end of the transition, ready for the application of the tipping pulse of a measuring sequence. The change in the magnitude of the magnetization is controlled by T1, which is generally of the order of hundreds milliseconds to many seconds for fluids, and the Larmor period is typically tens of nanoseconds to microseconds, so this condition is easily satisfied if the field transition occurs in a few tens to hundreds of milliseconds. In that case the magnetization magnitude will be substantially larger during the subsequent measurement than it would have been had the magnetization been initially allowed to build up with only the weak measuring field applied.

It was stated previously that the design of the static magnetic field for a borehole NMR tool must achieve a trade-off between a field that is strong enough to provide sufficient magnetization, yet homogeneous enough to provide an acceptably large sensitive volume within the pulse power limits. As the diameter of the tool decreases it becomes increasingly difficult to achieve this trade-off, and below about 14 cm (five and a half inches) diameter it has not been achieved in a commercial tool. A simple scaling down of the existing designs reduces the NMR signal much more than it reduces the thermal noise in the receiver system, so that the SNR becomes too small. Averaging of the data from successive measurements can be used to improve SNR, of course, but only in proportion to the square-root of the number of data sets averaged, so a reduction in SNR by a factor of four requires sixteen times more averaging. If the tool is moving up the well-bore continuously whilst logging, then either the logging speed must be substantially reduced in comparison with larger diameter tools, or a very large reduction in the vertical resolution must be accepted. Neither of these are commercially acceptable.

A further constraint in a borehole tool, or other system with limited power available, is that the field change does not involve switching on an electromagnet to superimpose an additional field onto that from the permanent magnets.

A final constraint specific to a small diameter borehole tool is that the measurement field, which is intentionally made uniform to maximise the size of the SV yet becomes weak in the process, is not so weak that the superposition of the Earth's magnetic field distorts it significantly.

These design constraints can be met if a permanent magnet array is designed with one or more physically moveable elements. The moveable element is moved from one position to another in a controlled way, within the acceptable time limits described above, to re-arrange the magnetic circuit and switch between the two magnetic field states. This arrangement can be achieved in a number of ways, and some examples are shown in Figures 4 to 8.

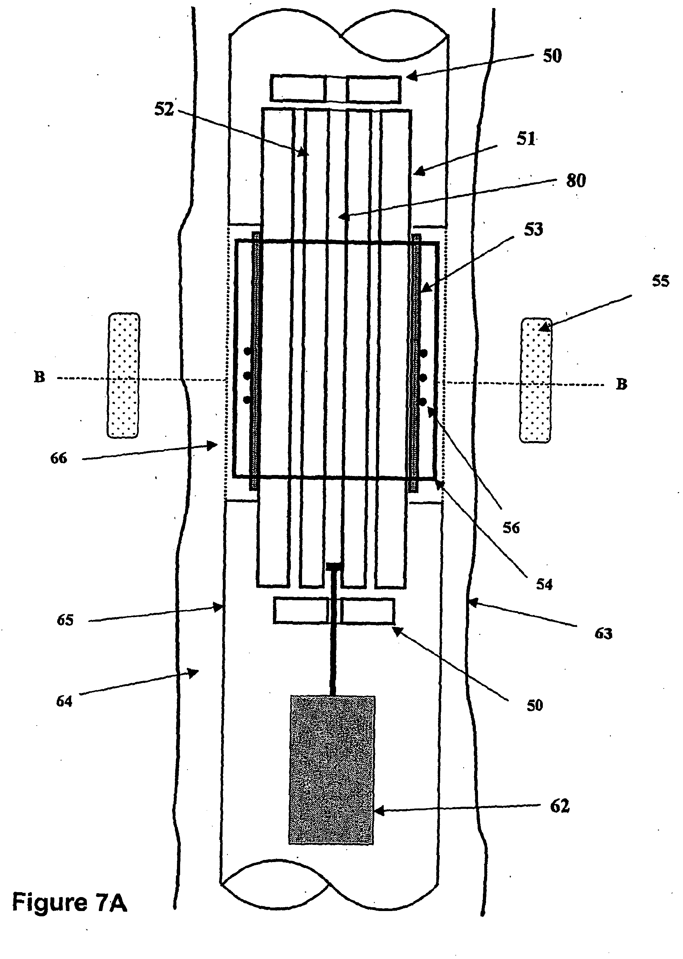

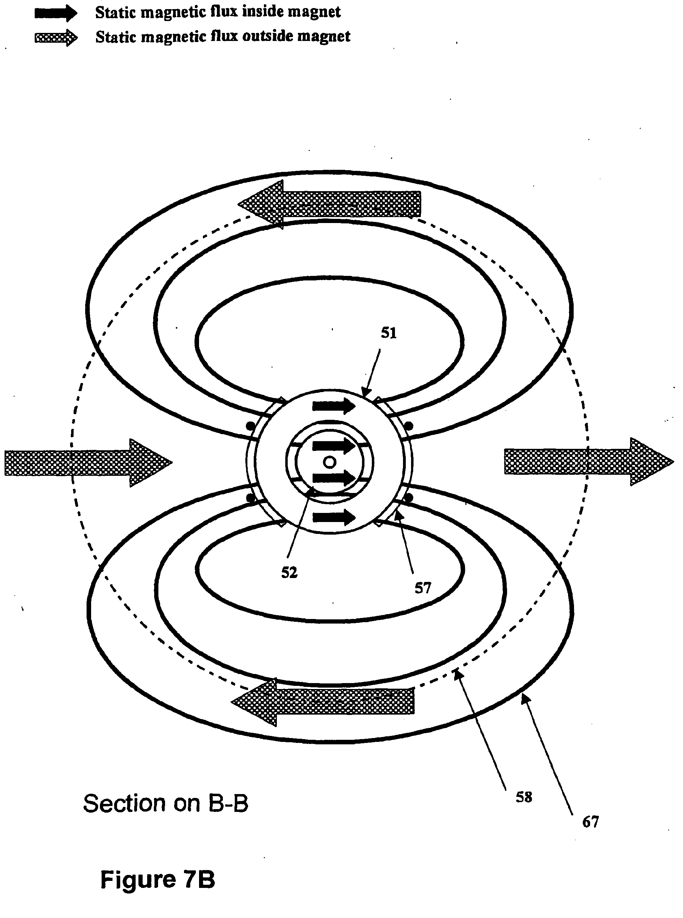

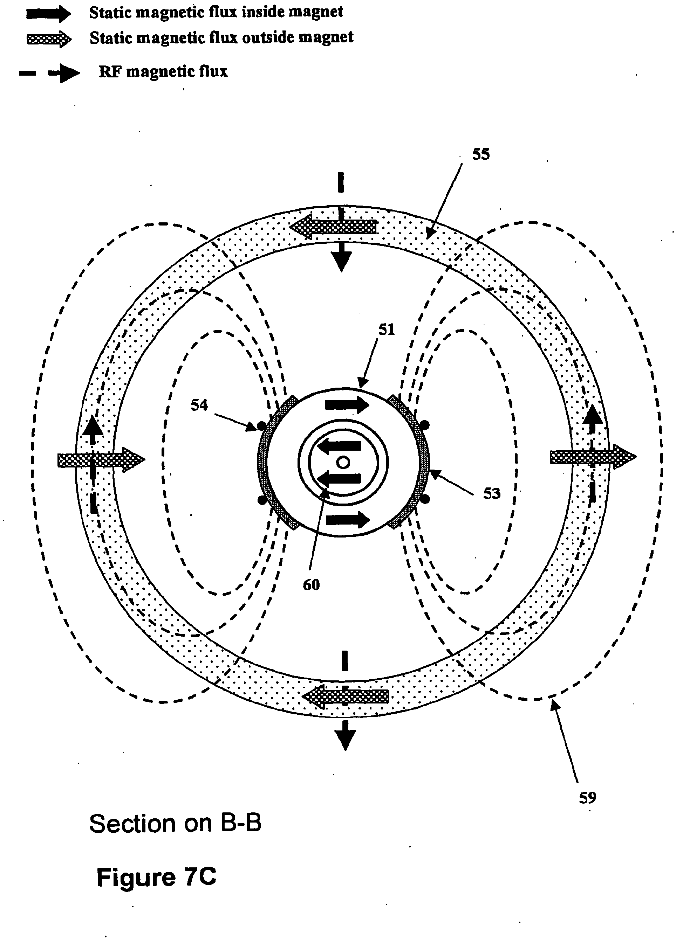

Referring to the embodiment in Figures 7A to 7C by way of illustration, where a cylindrical co-ordinate system RZΨ is used to described the geometry, with the Z axis along the long axis of the tool, the R axis radial and the Ψ axis azimuthal. The NMR sensor is based on the apparatus of US-A-4710713, but is only 60mm in diameter and incorporates improvements and modifications, in particular the addition of the moveable magnet element. The sensor is placed within a cylindrical metallic pressure housing (65) and lowered into the borehole (63). The sensor is centralised in the hole by means of mechanical arms or springs (not shown) because the sensitive volume is a cylindrical shell (55). The cylindrical magnet array is made from high energy rare earth material, such as NdFeB or SmCo and comprises a fixed outer magnet (51) and a moveable inner magnet (52). Both magnets are magnetized across their axis, as shown by the solid arrows in Figures 7B and 7C, and the inner element can be rotated through at least 180_ (Figure 7C, 60) so that their fields either add or subtract. The magnetic field produced in the two states has a dipole-like shape in the transverse RΨ plane, as shown in Figure 7B (67). A rotary solenoid or stepper motor (62) can be used to achieve the rotation in the correct time in a controlled fashion. Of course many other methods of actuation are possible, such as hydraulic, pneumatic, mechanically stored energy, such as a spring or memory metal, or piezo-electric or thermal expansion for embodiments that require smaller movements. There will be a substantial force for several Newtons to overcome in rotating the magnets. In the measurement state the magnet assembly is stable, requiring no holding force, and in the pre-magnetization state the assembly is meta-stable, requiring no holding force unless perturbed. The inner and outer magnets would typically be made by stacking smaller ring-shaped elements. In general it is preferred to move the inner magnet and leave the outer one fixed, but this is not a limitation of the invention.

In the embodiment of Figure 7B the pre-magnetization or pre-polarization field has an intensity of 0.04 T (400 Gauss) in the centre of the SV (55) at a radius of 85mm (58), and the field intensity falls away with distance from the magnet such that the static field gradient across the SV is approximately 1.3 T/m (130 Gauss/cm). The relative diameters of the inner (52) and outer (51) magnets are selected so that in the measurement state (Figure 7C) the field from the inner magnet cancels a large proportion of the field from the outer magnet, such that the measurement field is much less intense than the pre-magnetization field, but the field gradients are also substantially reduced. The measurement field must, however, be large compared to the Earth's field (approximately 5x10⁻⁵ T) (0.5 Gauss), depending on geographic location). In the embodiment of Figure 7C the measurement field at the centre of the SV (radius 85mm) is 3 mT (30 Gauss), and oriented in the same direction as the pre-magnetization field (although this is not a requirement of the invention). The inner magnet therefore cancels about 90% of the field from the outer magnet. However the radial gradient of the static measurement field is now only 0.09 T/m (9 Gauss/cm).

In order to appreciate how the reduced gradient of the measurement field increases the radial thickness of the SV let us consider the bandwidth covered by a typical RF re-focusing pulse for a practical logging tool. Typically the peak RF power that can be transmitted by the antenna of a practical logging tool is limited to a few tens of kilowatts. This is sufficient to generate RF pulses of typical duration tens of microseconds in which the amplitude of the oscillating magnetic field generated in the SV, at the Larmor frequency defined by the ambient field in the SV, is a few Gauss (G). The precise amplitude and duration of the pulses depends on the antenna design and dissipation characteristics of the borehole and formation, but the pulses are controlled by the system's electronics to generate the required rotation of the magnetization, as described above. By way of example, let us assume the re-focusing pulse duration is 30µS. The effective bandwidth of the RF pulse is therefore approximately 33kHz (bandwidth = 1/pulse length). The gyromagnetic ratio of hydrogen is 42.58 Khz/T (4.258 kHz/G), so the RF pulse must be applied with a frequency 4.258*30 = 127.7kHz to tip and re-focus magnetization in the SV. The thickness of the SV can be calculated from the RF bandwidth and static field gradient:
0.09 T/m (9 Gauss/cm) implies 4.258*9 = 38.3 kHz/cm, so the radial thickness is 33/38.3 = 8.7mm

If one were to attempt to make the NMR measurement by applying RF pulses in the pre-magnetization field the radial thickness of the SV would only be:
1.3 T/m (130 Gauss/cm) implies 553.5 kHz/cm, so SV radial tickness = 33/553.5 = 0.6mm

This is much too thin for practical measurements if the tool is moving during the pulse sequence, because the conditions for correct re-focusing of spin echoes would not be maintained across the SV. Furthermore the volume of the SV would only be 7% of its volume if the RF pulses were applied in the measurement field and the NMR signal would be reduced in proportion. A further problem is that the RF pulses would have to be applied at a Larmor frequency of 4.258*400 = 1.7MHz, and the high voltages present in the antenna system scale directly with antenna impedance, which rises with frequency.

Therefore it is clear that there are many advantages in applying the RF pulse sequence when the tool is in the measurement field state. Conversely however, if the magnet array were permanently in the measurement state, so that the magnetization built up only in the measurement field, then the NMR signal would be reduced by the ratio of the measurement and pre-magnetization states, i.e.: to 30/400 = 7.5% of the signal that would have been achieved if the magnetization had built up in the pre-magnetization field state. Therefore the advantage of the greater sensitive volume in the measurement state is cancelled by reduced magnetization. It is therefore clear that the magnetization must build up in the strong (0.04 T (400 G)), non-uniform (0.013 T/cm (130 G/cm)), pre-magnetization field, and the RF pulse sequence and NMR measurement must be made in the weaker (3 mT (30 G)), but more uniform (0.09 T/m (9 G/cm)) measurement field. This can be achieved with the moveable magnet of the invention.

In an alternative embodiment the ratio of the inner magnet to outer magnet diameters could be made larger so that the inner magnet field completely over-powers that of the outer magnet in the measurement state, creating a measuring field with similar intensity to that of the embodiment described above, but in the opposite orientation to the pre-magnetization field. Note that, unlike the apparatus of US-A-4717877, the external magnetic field is not reduced to zero when the inner and outer magnets are opposed, but rather to a weaker intensity.

The magnet array could be made of ferrite permanent magnet material as described in US-A-4710713, but the much lower volume of magnet material in this small diameter tool means that a material with inherently higher remanence confers a major advantage. The magnet material should have sufficient coercivity to resist de-magnetization when the fields from the two magnets are in opposition. The required properties are offered by rare earth materials such as SmCo and NdFeB alloys. SmCo is particularly suitable for high temperature environments because of its improved temperature stability, but the higher remanence of some NdFeB grades is preferred in lower temperature applications. Both materials have sufficient coercivity to resist de-magnetization effects. The exact properties, such as remanence and coercivity, of magnet materials used for the various parts of the magnet array need not be identical. The example described above is based on a magnet array made from high energy product sintered NdFeB material.

A problem with rare earth magnets compared to ferrite is that they are highly conductive. If the RF antenna has to encompass or lie close to the magnet structure then the RF pulses will induce unacceptable eddy currents in rare earth magnets, wasting power and reducing the gauss/amp efficiency of the antenna.

For this reason it is necessary to place a layer of magnetically soft (i.e.: having substantial effective permeability) ferrite (53) between the RF antenna windings (54, 56) and the conductive magnets to carry the RF magnetic flux, as described in EP-A-0932055. Care must be taken that the grade of soft ferrite is chosen correctly so that the ferrite does not saturate due to the combined magnetic fields of the permanent magnet array in measurement mode and the RF pulse. When the tool is in the pre-magnetization state the static field is so intense that in general any grade of ferrite will be saturated and have no effective permeability (shown pictorially as 57 in Figure 7B by the lack of shading) but this is not a particular problem because typically no RF pulses are applied in the pre-magnetization mode in the method of the invention. However, when the field is in the measuring state the soft ferrite can be placed around the magnets in the positions shown in Figures 7B and 7C, where calculations (carried out using the finite element method) show that it will not saturate and will thus provide a return path for the RF magnetic flux (59). In general it is found that the ferrite retains enough permeability to enhance the efficiency of the antenna compared to a conventional antenna with an air or permanent ferrite magnet core. Therefore the switched magnet system confers the additional benefits of (a) allowing the use of rare-earth materials for the magnet array, giving stronger fields per unit volume than ferrite permanent magnets, and (b) using soft-ferrite in the RF antenna, giving improved antenna efficiency.

Referring again to Figure 7A, one-piece end-cap magnets (50) are used to shape the magnetic field, ensuring that the magnetic field intensity in the measurement state at the radius of the cylindrical SV is constant along a substantial proportion of the axial length of the magnet array. Therefore the SV shell (55) forms at a uniform radius and falls within the formation rocks and not in the borehole (64). The SV shell must have a uniform diameter along its entire length if the tool is to be operated when moving up the borehole, otherwise "out-flow" effects will create errors in the T2 data. The axial length of the SV can be made as long as desired simply by extending the length of the sensor until the required single-shot SNR is achieved. The end cap magnets (50) do not need a rotating element as their field contribution is only significant in the measurement state. A through-hole (80) is provided through the entire magnet assembly for feed-through wiring.

There are several geometry options for the RF antenna, falling into two major classes. As shown in Figures 7A to 7C one or more conducting loops (54) may formed in a loop in the RZ plane, around the magnet structure, and oriented so the dipole-like RF field (59) produced in the RΨ plane is rotated by 90 degrees with respect to the magnet field (67), such that the RF field flux is generally orthogonal to the static field flux at all points: Alternatively one or more conducting loops may be placed around the magnets in the RΨ plane (56 in Figure 7A) which produce RF flux oriented in the axial Z direction. In a preferred embodiment one type of coil is used for transmitting the RF pulses and the other type for receiving the NMR echo signals. The coils are mutually orthogonal and do not couple significantly. Their respective design can be optimised for the different tasks of transmit and receive. In both cases the conducting loops of the antennas are positioned to create fields that have the optimum geometry and efficiency, following design guidelines familiar to those skilled in the art.

The geometries chosen for the transmit and receive antennas in a twin antenna system can be swapped over, depending on which arrangement is found to provide the best performance, or the same antenna can be used with a transmit-receive switch, as described in the prior-art.

An RF transparent window (66) made from a non-conducting material such as fibreglass is provided in the pressure housing (65). Only the antennas and ferrite layer need to be outside the metallic housing (through which RF fields cannot penetrate), whilst the magnets can be kept at atmospheric pressure within the a hermetically sealed pressure housing - this solution is adequate for shallow holes. For deeper holes, it would be preferable to fill the sensor assembly, including the stepper motor, with a hydraulic fluid, such as silicone oil, and balance the interior pressure with the external borehole pressure by means of a diaphragm or bellows and a vent hole a method well known to those versed in the art (not shown in Figures). If correctly designed the oil could also convey the benefit of mechanically damping the magnet motion during the field switching process, ensuring smooth motion and minimum settling time.

Standard electronics (not shown) is provided within the pressure housing above or below the sensor to generate RF pulses at the required time intervals and with the required phase, to receive NMR signals and to actuate the magnet position switching at the appropriate intervals. The downhole electronics can store measurement data to memory and/or send it to the surface, either by means of a wireline cable, mud-pulse telemetry system, or other down-hole communication device. Typical electronics and communications systems are described in US-A-4710713, US-A-4933638 and US-A-5969527.

The method of the measurement is explained with reference to Figures 3 and 7. The logging tool is continuously moving up the bore-hole at a constant speed. The apparatus of Figure 7A is moved into the pre-magnetization state (Figure 7B), in which the magnetic fields from the inner (52) and outer (51) magnets add, for a wait time TP (Figure 3C) that is preferably three to five times as long as the longest T1 of the formation fluids of interest. Magnetization builds up in the strong pre-magnetization field (67, represented by large hatched arrows), which for the 60mm diameter tool in the example is typically 400 Gauss within the SV (55), at a radius of 85mm (58). The logging speed must be sufficiently slow that the apparatus remains substantially within the same formation for this period. The inner magnet (52) is then rapidly rotated by 180 degrees (60, Figure 7C) into the measurement position so that its field subtracts from that of the outer magnet, reducing it to a much weaker value (represented by smaller hatched arrows), typically 30 Gauss at the same radius. This is still about sixty times the intensity of the Earth's field, so the effect of the Earth's field can be largely neglected. (Note that the arrow vectors used to represent the direction and intensity of the magnetic flux in the Figures are pictorial only, but larger vectors do represent more intense field. However, the flux density inside the magnets is very much larger than in the SV, so these vectors are scaled down.)

The time taken to switch field states must fall within the limits described previously, but in practical terms the magnet rotation is made as fast as possible, as the minimum time to physically rotate a magnet cannot be less than a few milliseconds. The magnet system will take a short time to settle after switching, time period TS in Figure 3A, after which the tipping pulse T_{X} in a CPMG sequence is applied, typically using the RZ plane antenna (54). The measurement field has a much weaker radial gradient than the pre-magnetization field so the bandwidth of the tipping pulse "tagus" spins over a cylindrical shell with significant volume (8.7mm millimetres radial thickness for a 30us pulse and the exemplary tool dimensions previously used) and a significant axial length (200 to 400mm or more, in proportion to the axial length of the main magnets). The enhanced magnetization within the SV (55) is rotated into the transverse plane by the tipping pulse where it dephases due to magnetic field inhomogeneity with time constant T2*. The rest of the CPMG sequence is applied as normal,' causing the transverse magnetization to repetitively re-focus and induce echoes (6a,b,c in Figure 3C) in the receive antenna, typically the RΨ plane solenoid coil (56), but the same antenna as used for transmitting RF pulses can be employed.

In a typical inside-out NMR system the RF pulse power is so great that it causes significant electromagnetic "ringing" in the sensor, sometimes called "coil disease" by NMR practitioners. This ringing induces a signal in the receiver which can be larger than the NMR signal. If this is the case, it is usually possible to repeat the measurement sequence with the phases of the re-focusing RF pulses reversed, and to subsequently subtract the data sets from the two measurement sequences. This will remove the ringing artefact from the re-focusing pulses, as well as any other baseline artefacts. This method, know as Phase Alternated Pair (PAP) acquisition, is well known in the NMR literature and described in US-A-5023551. If necessary, it can be applied here with the proviso that the magnet is switched back into the pre-magnetization state for duration TP before each individual CPMG sequence.

The echo train data thus acquired can be analysed to separate the contribution from "free-fluid" in large pores (long time constants) and "bound-fluid" in small pores or clay (short time constants). There is of course a limit to the shortest time constants that can be measured by this method related to the transition time from one field state to the other. This limitation can be overcome by interleaving the measurements taken by the switched-field method, which gathers high quality data on free-fluid, with a series of measurements carried out in a conventional manner in which the magnet system is held in one state (typically the measurement state), to acquire data pertaining to the bound-fluid. Due to the fast-recovery nature of the bound fluids (which have short T1) the magnetization recovery delay TW required in the pulse sequence is much shorter than in the switched field method (tens of milliseconds compared to seconds), and the number of pulses required per sequence is far fewer (tens rather than hundreds), so the bound-fluid signal measurement can be repeated very often in a short time period, in the form of PAPs if necessary, and the results averaged to boost the NMR signal to the same level as for the switched field measurement. This approach is used to advantage for fast logging or measurement while drilling as described in US-A-5363041. The data from the two measurements can be combined according to the method described in "The Inversion of NMR Data Sets with Different Measurement Errors", Dunn, K. et al, J. Mag. Res. 140, 153, 1999).

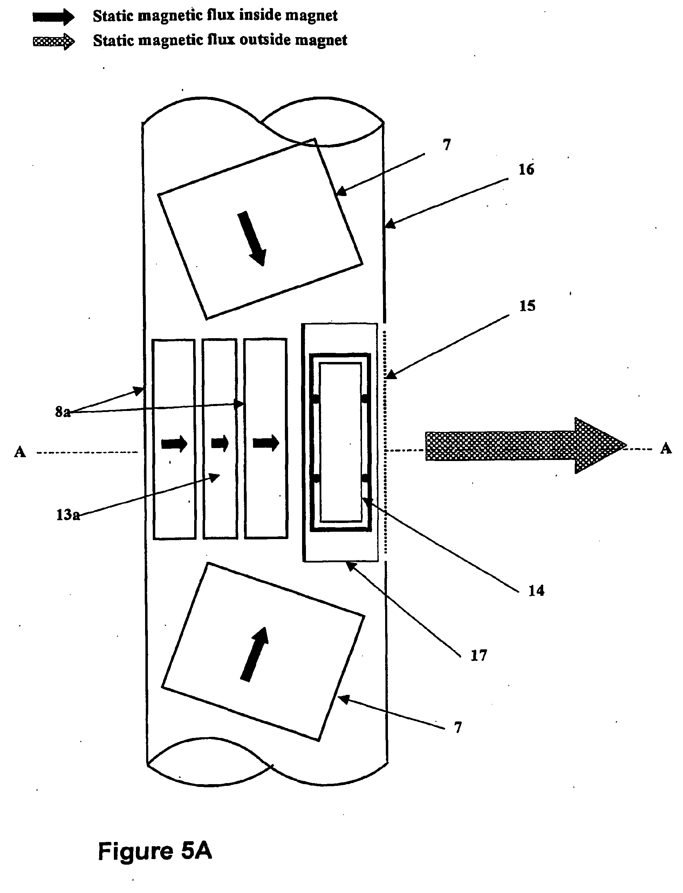

The embodiment of Figures 4A to 4C is based on the sensor geometries described in US-A-4350955, US-A-5471140, US-A-5488342 and US-A-5646528. In such a conventional system, the main magnet poles (7) are positioned to produce an azimuthally symmetric region of relatively homogeneous magnetic field at the saddle point that occurs in the field in a toroidal volume around the sensor. The sensor is then centralised in the borehole. This approach has the disadvantage that the tool must be designed for the largest hole in which it will be used, which results in a large SV diameter to tool diameter ratio, is not conducive to good NMR signal strength with this particular magnet geometry. In general it is necessary to have two or more tool sizes to cover the range of hole diameters - an undesirable situation from a logistical and cost perspective. A potentially better alternative is to offset the tool in the hole and arrange that signal is acquired from one side only. This is achieved by means of changes to the magnet and RF system to make them azimuthally asymmetric. The sensor assembly is housed in a cylindrical metallic tube (16) with an RF transparent window (15). Figures 5A to 5C show an alternative way of arranging the shim magnets as two concentric cylinders, magnetized across their axis.

The probe body is held off-centre in the hole by mechanical means, such as a bow-spring (not shown), so that the window is held against the borehole wall (72). The sensitive volume (71) is formed in the formation rocks. This configuration is often called a "pad" tool. However the pad tool version has the disadvantage of making less efficient use of the stored magnetic energy, i.e.: the SV is smaller for the same volume of magnetic material, compared to the centred version. The method of the invention is used to counter-act this disadvantage.

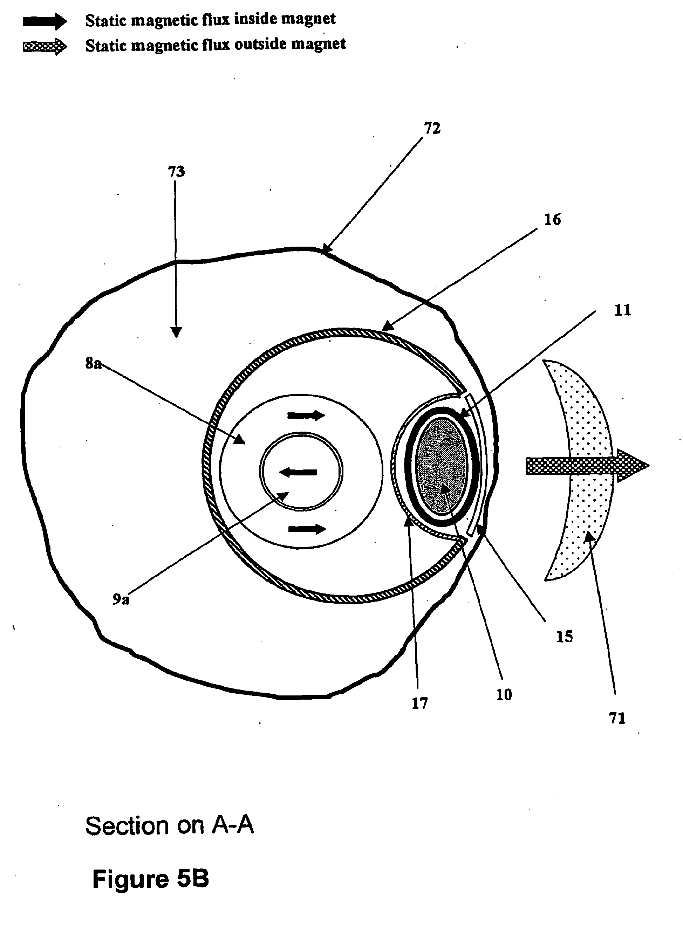

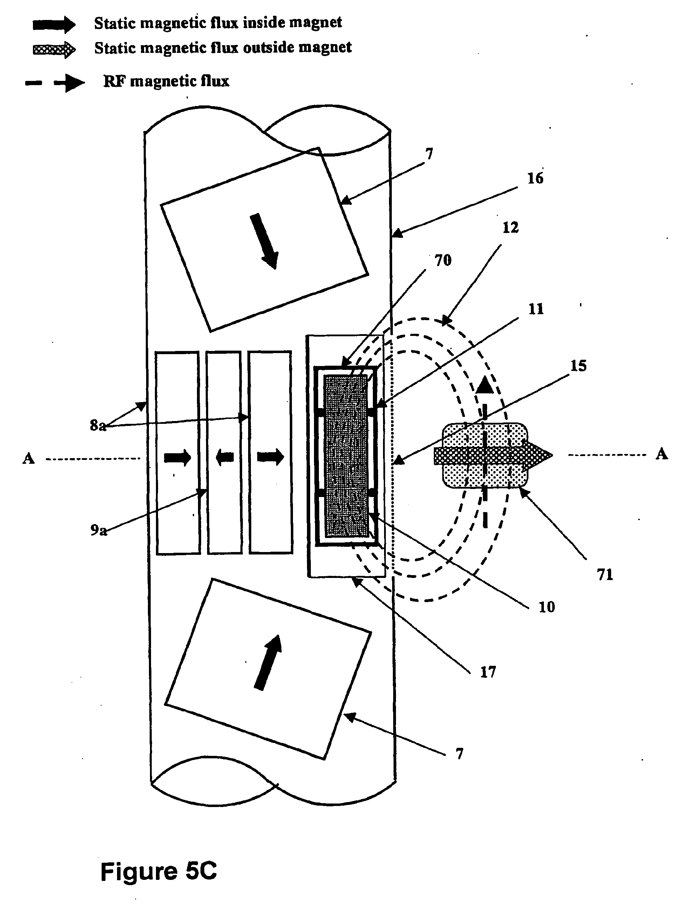

These sensors are once again best described by a cylindrical co-ordinate system. As shown in Figures 4A and 5C, the main magnets (7) can be tilted which enlarges the SV dimensions on one side of the tool and reduces then on the other side, and a shimming magnet or magnets (8, 9, 13) is used to offset the SV (described in US-A-5488342). The optimum tilt angle is determined by finite element modelling of the magnetic field. The RF system is designed to be sensitive only to the enlarged SV on the formation side of the tool. This may be achieved as follows. Firstly the azimuthal aperture of the RF transparent window subtends only a portion of the housing and is positioned against the borehole wall, so the RF field is restricted by the window. There are then a number of choices for RF antennas: A single antenna may be used for both transmit and receive or twin antennas may be used. The one-sided version of the geometry allows the option of orthogonal antennas - not possible in the conventional symmetric version. One antenna is formed from one or more conducting loops in the RΨ plane (11), producing RF flux (12) in the Z direction in the SV (71). The second antenna is formed from one or more conducting loops in the RZ plane (70) producing RF flux orthogonal to the page in Figures 4B and 5C. The antennas may be filled with soft ferrite (10, 14) to improve their gauss/amp efficiency. Again the grade of ferrite must be chosen so that it does not saturate under the combined RF and static measurement fields (unsaturated ferrite is labelled 10, saturated ferrite with unity relative permeability is 14). In all embodiments it can be advantageous to make the ferrite from small elements so that dimensional resonance cannot occur (see EP-A-0932055). A conducting shield (17) may be placed behind the antenna system to improve the directionality according to US -A-5646528. Alternatively the shield may form part of the conductor circuit for the RZ plane antenna - the so-called "trough" antenna of US-A-5153514. The combination of asymmetric magnetic field and RF system result in a sensitive volume that is a dished disk or cusp shape (71 in Figure 5B) in the formation rocks.

In this arrangement a number of ways to create the switched magnetic field are possible, of which two are illustrated here. Figures 4A and 4B show an arrangement of three "shim magnets" (8, 9, 13) between the main magnets (7). The shim magnets may be disks or bars as required. The outer shim magnets (8) are fixed and polarized as shown in Figure 4A so that their field adds to that from the main magnets. The inner shim magnet can be rotated by 180 degrees between two positions (9 and 13) so that its field either adds to or subtracts from the field from the outer shim magnets (8). In Figure 4A all the fields add, generating a strong pre-magnetization field, but imposing a strong radial gradient across the SV. The field in the vicinity of the ferrite is strong and the ferrite probably saturates (14). In Figure 4B the field from reversed shim (9) largely cancels that from shims (8) and the measuring field in the SV is mostly due to the main magnets (7) so it exhibits the natural saddle point, but is necessarily weaker. The field in the vicinity of the ferrite is now much weaker and the ferrite does not saturate (10).

In the Figure 5 example the outer cylinder (8a) is fixed and the inner (9a, 13a) rotates by 180 degrees from the pre-magnetization position (13a) to the measurement position (9a). Figure 5B shows this arrangement in plan section.

In an alternative embodiment (not shown in Figures) it would be possible to do away with the shim magnets (8, 9, 13, 8a, 9a, 13a) altogether and simply move the main magnets (7) axially closer together to produce the stronger, less uniform pre-magnetization field at the diameter of the SV. This embodiment uses linear motion and may be mechanically more complex and costly to implement than rotary motion.

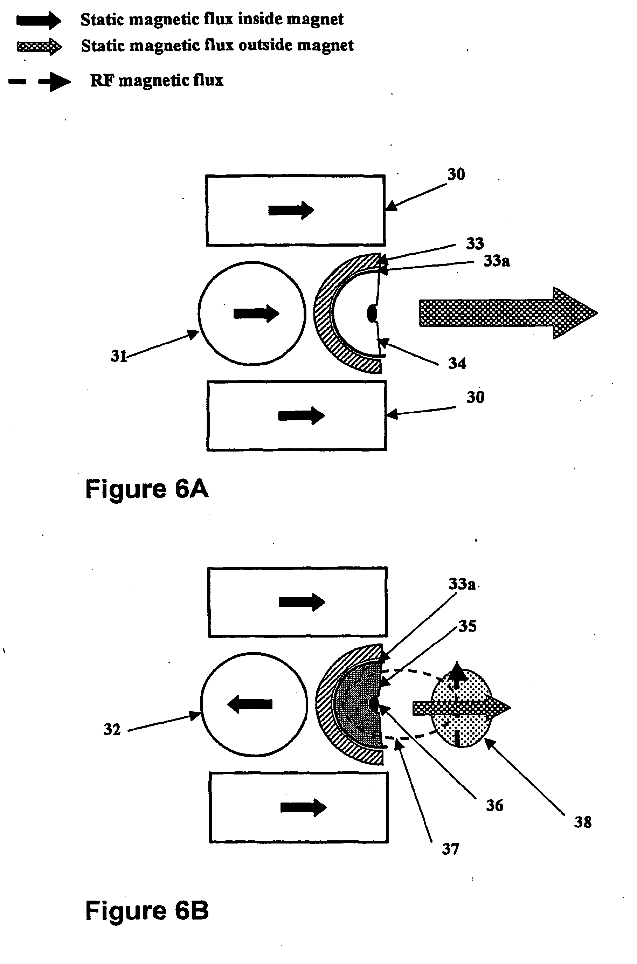

Figures 6A and 6B show an alternative arrangement based on the geometry in US-A-4933638. The housing and RF window are not shown, but would be similar to that shown in Figure 5B. The sensor is one-sided and is operated as a pad tool. The main bar magnets (30) generate a saddle point in the magnetic field which is used for the SV (38). A third magnet (31, 32) may be rotated from the pre-magnetization position (31) to the measurement position (32). A trough antenna (33, 34, 35, 36) of the type describe in US-A-5153514 is shown, although the antenna systems shown in Figures 4 and 5 and described above are equally applicable. In this geometry the close proximity of the main magnets to the ferrite core (34, 35) usually requires that an iron flux shunt (33) is used to route the magnet flux away from the antenna ferrite so that it does not saturate in the measurement state (35). The RF flux (37) from the axial conductors of the trough antenna lies in the RΨ plane. The trough antenna shown in this example uses the shield (33a) as the return current conductor, as described above.

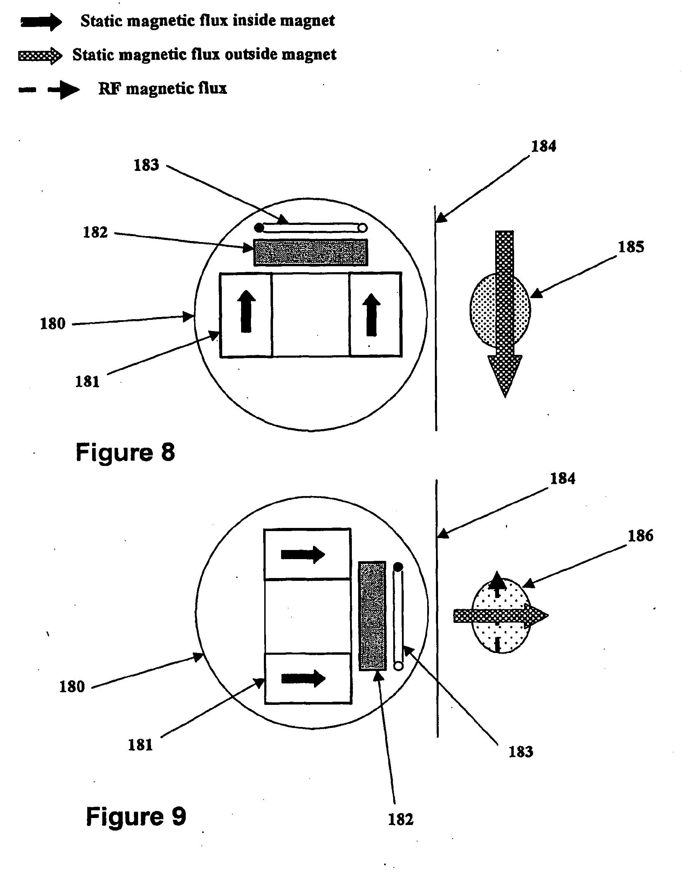

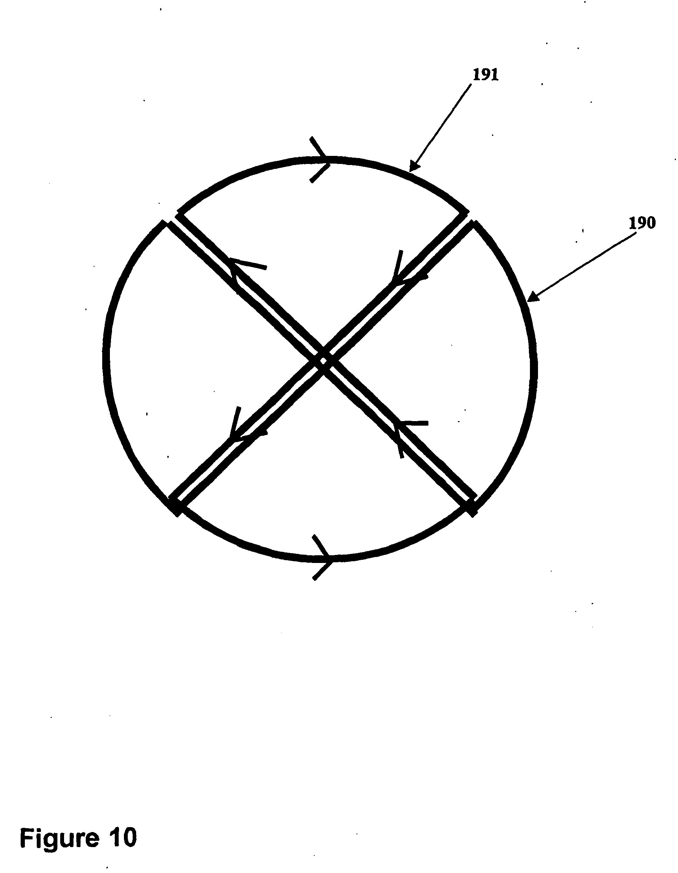

Figures 8 and 9 show another embodiment, this time applied to a one-sided NMR external field sensor for surface investigation. An annular permanent magnet (181), shown here in section, is magnetized along the axis. This ring magnet is functionally equivalent to a simple pair of nested solenoids. A ring magnet produces a field with a saddle point and a region of improved homogeneity at both ends. If required a ferrite layer (182) can be used to adjust the field shape (at one end in this example) and enhance the RF sensitivity as previously described. More complex magnet structures comprising concentric rings of magnets, some with reversed magnetic polarity, can be envisaged to improve the field homogeneity, but always at a cost of field strength in the SV. An MR imaging system similar to this embodiment, but which does not utilise pre-polarization, is described in US-A-5959454. An antenna system well suited to this geometry is the "crossed butterfly coils" or gradiometer coils shown in plan view in Figure 10. Two antennas (190, 191) are wound using "figure of eight" windings and laid out so RF flux loops out of one half of the figure-of-eight and into the other half. In this way the transmit and receive fields produced in the SV are in the same plane as the coils and orthogonal to the static magnetic field and to each other. This twin coil system, described in OA 4.2K receiver coil and SQUID amplifier used to improve the SNR of low-field MR images^{o}, Seton H, et al, Meas. Sci. Tech. Vol. 8, 198-207, 1997, is naturally orthogonal and has minimal cross-coupling. In Figures 8 and 9 the butterfly antenna pair (183) is laid out on the ferrite disk (182).

The apparatus shown in Figures 8 and 9, which does not represent an embodiment of the current invention, can be used to investigate the properties of materials below a surface (184). To gain the signal enhancement of the present invention the apparatus must first be placed as shown in Figure 8, so that the strong but inhomogeneous static magnetic field beside the magnet causes magnetization to build in the region of interest (185). The apparatus is then rotated by about ninety degrees (or the sample is moved) so that the weaker uniform field in front of the antenna envelops the material of interest (Figure 9) and a measurement is made in the SV (186). It is possible to think of the apparatus of Figure 8 and 9 as an alternative embodiment of the apparatus of Figures 6a and 6b, but moving the whole apparatus (or sample) instead of the shim magnet (31/32).

In a further embodiment (not shown) based on that shown in Figures 8 and 9 the direction of magnetization of any reversed polarity element that may have been introduced to improve homogeneity in the SV, (but which inevitably weakens the static field) can be cancelled during the pre-magnetization period by means of a current pulse in a winding enclosing the reverse magnetized element. In this case, to avoid the positive elements being affected by the current pulse, they should be made of a magnetic material with a greater coercivity than that of the element whose magnetization is to be reversed. For example, a high coercivity rare earth material or type C5 permanent magnets ferrite, which has a remanence of 300mT and a coercivity of 200kA/m could be used for former, and type Cl ferrite which has a remanence of 220 mT and a coercivity of 150kA/m could be used for the later.

In yet a further example (not shown) based on that shown in Figures 8 and 9 the pre-magnetization field enhancement may be generated by switching on an electromagnet loop coil positioned in the same plane as the RF coil (183). This electromagnet can be resistive or superconducting. If the latter, it may be wound from low temperature or preferably from high temperature superconductor, thus easing the requirements for cryogenic cooling.

We now turn to exemplary embodiments of the invention in the field of MR imaging in which the pre-polarization method is combined with open-access magnet designs suitable for MRI. The method and apparatus allows the current in some winding sections of the magnet to be changed to temporarily re-configure the magnet geometry (magnetic circuit) so that the magnetic field strength in the sample during the pre-polarization period is increased, without increasing the stored magnetic energy in the magnet. An exemplary preferred embodiment is now described for a one-sided MRI system based on the flat magnet of US-A-4701736.

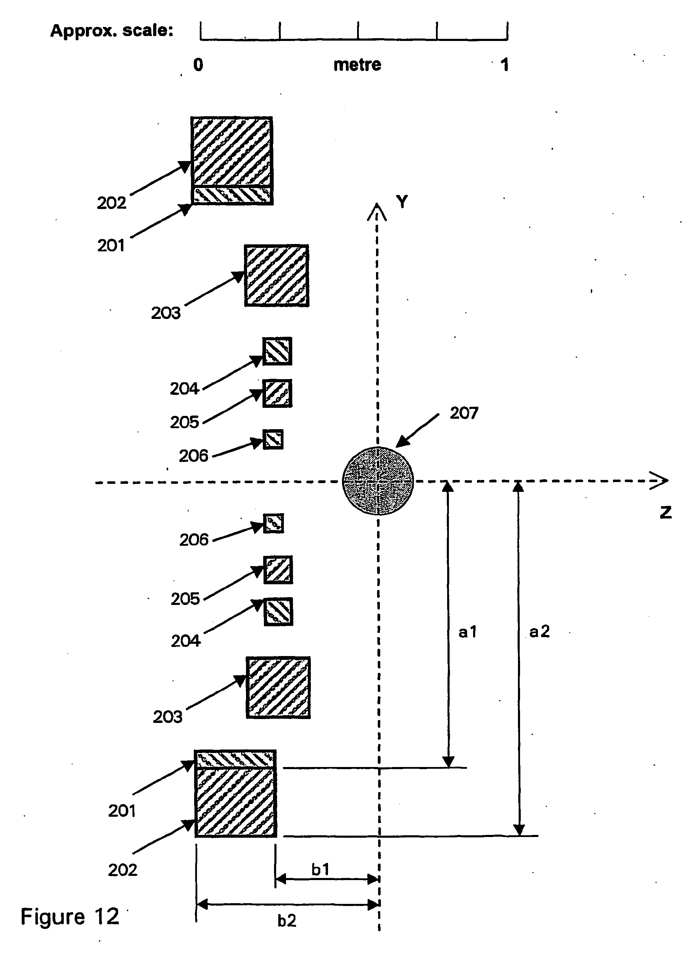

Figures 11 and 12 show an example of a maximum access imaging system magnet for general purpose medical imaging. The dimensions of the example are particularly suited to limb, head and spine imaging. This "flat magnet" example generates a very homogeneous magnetic field across a spherical homogeneous sensitive volume in measurement mode, offset from the plane of the magnet. A spherical SV is often referred to as a "diametrical spherical volume" (DSV) in NMR terminology, and is the most general purpose SV, well suited to internal-field instruments. As will be clear to those versed in the art, it is possible to optimise the magnet geometry in other ways to create other shapes of sensitive volume. One particularly useful option for extreme open-access external-field instruments is disk or "saucer" shaped sensitive volumes. Descriptions of magnet systems optimised for disk and saucer shaped SVs are given in US-A-5307016 (for solenoid magnets) and US-A-5331282 (for one-sided magnets). It is not intended to limit the invention to flat magnets with spherical sensitive volumes.

The Cartesian axis system shown is used throughout this application. The magnet comprises a static-field sub-magnet (coils 202, 204, 206) and a variable-field sub-magnet (coils 201, 203, 206). The outer coil diameter is approximately 3 metres. The coils are all in the XY plane, offset along Z by about 30cm (except 201 & 202, which are offset by 40mm) from the origin, where the imaging volume is centred. The imaging flux density is 0.1T in read-out mode, and 0.44T in pre-polarization mode. The coil positions and turns densities are selected to achieve near zero mutual inductance between the static-field sub-magnet and the variable-field sub-magnet, as well as a homogeneous read-out field, and a pre-polarization field with a linear Z-gradient across the imaging volume (207). (This system could obviously be scaled down for imaging of smaller body parts or scale up for imaging of larger subjects, or redesigned for a larger or smaller separation of the magnet and DSV along the Z axis).

The Cartesian co-ordinate system (200) is shown in Figure 11, with the Z axis along the magnet coil axis. The coil winding parameters are given in Table 1, which should be read in conjunction with Figure 12, which schematically shows the magnet coils in cross-section, with dimensions al, a2, b1 and b2 indicated.

**Table 1: Flat 0.1T magnet for one-sided imaging system (current directions shown for read-out mode)**

| **Coil #** | **a1 (cm)** | **a2 (cm)** | **b1 (cm)** | **b2 (cm)** | **Turns** | **Current (amps)** |
|---|---|---|---|---|---|---|
| 201 | 121.18 | 125.28 | 27.18 | 52.82 | 1051 | 100 |
| 202 | 125.28 | 146.82 | 27.18 | 52.82 | 5523 | 100 |
| 203 | 76.24 | 93.77 | 21.24 | 38.77 | 3073 | -100 |
| 204 | 38.86 | 41.14 | 28.86 | 31.14 | 520 | 100 |
| 205 | 29.08 | 30.92 | 29.08 | 30.92 | 339 | -100 |
| 206 | 19.64 | 20.36 | 29.64 | 30.36 | 52 | 100 |

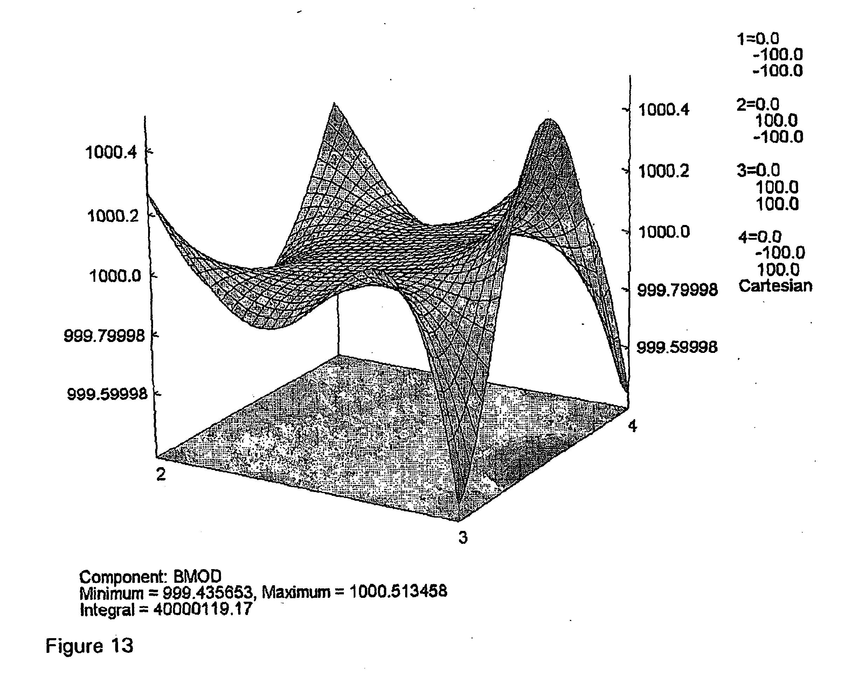

This magnet produces a 0.1T field at the origin in read-out or measurement mode. The field is uniform to 18 parts per million (ppm) over a 10cm diameter DSV 207 and to 230ppm over a 20cm diameter DSV centred on the origin of the co-ordinate system. Figure 13 shows a contour and surface plot of the field over a 20 by 20 cm patch in the YZ plane slicing through the DSV. In comparison with conventional solenoids (conventional defined here as having length to bore ratio grater than approximately two) and Helmholtz-configuration C-magnets (in which the gap between the coils equals the coil radius), the "flat magnet" contains windings with counter-running current (coil banks 203 & 205 in Table 1) It is a recognised fact that extreme open access magnets, with more patient access compared to conventional solenoids and C-magnets, must contain counter-running coils in order to create the homogeneous volume of field required for MR image read-out. The counter-running turns are positioned to generate field contributions that cancel un-wanted harmonics in the field in the SV, thus increasing homogeneity, but unavoidably subtracting from the field strength in the SV.

The stored energy of this magnet is 0.8MJ. For comparison purposes, a simple 1m bore, 2m long solenoid design, having the same stored energy and similar field homogeneity across the same size DSV at the magnet isocentre, would generate a flux density of about 1 Tesla.

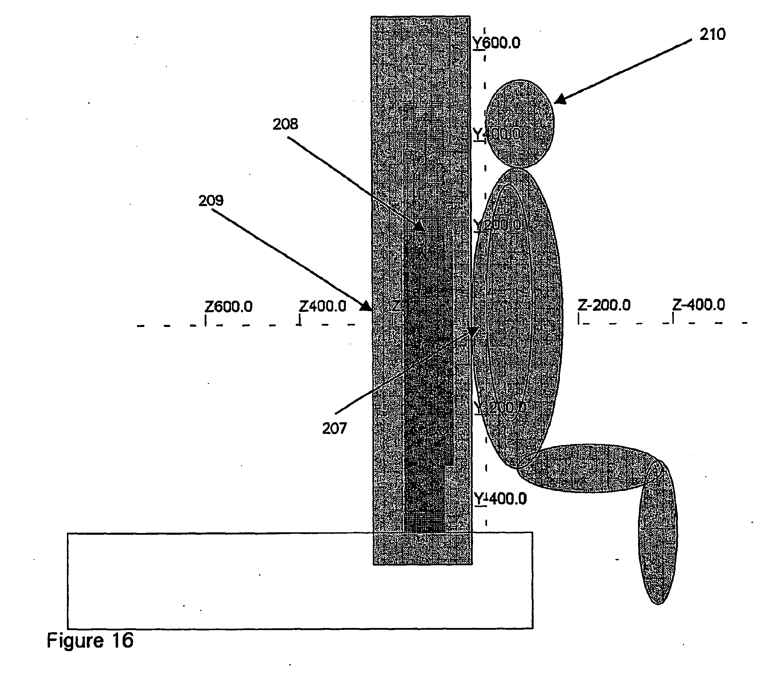

Figure 16 shows the flat magnet (208) in a pictorial cryostat (209) and a seated patient (210), demonstrating the spine imaging capability and extremely open access.

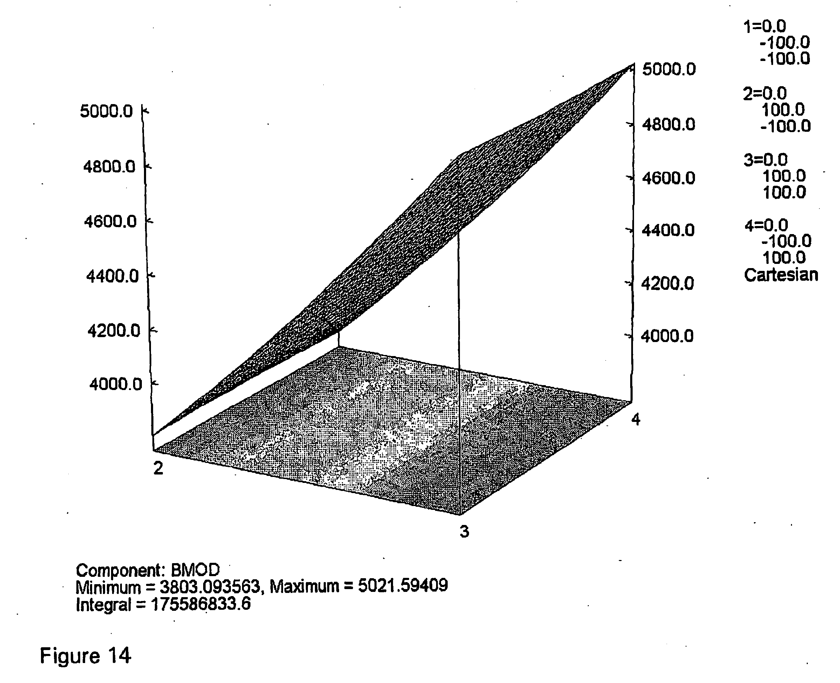

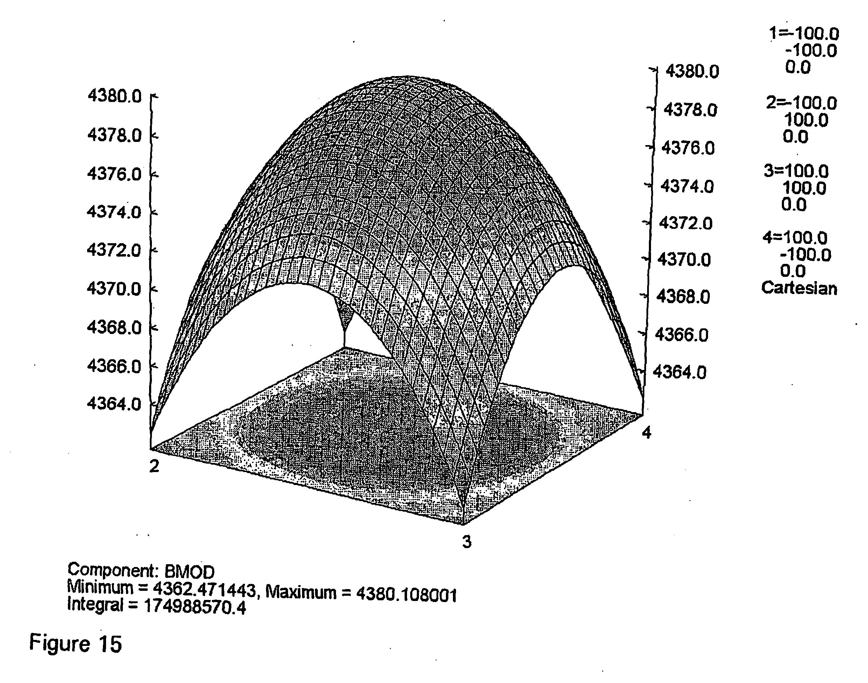

In this embodiment, and in comparison with prior art, the current in the odd numbered coils (201, 203, and 205) in the magnet of Figure 11 is reversed during the pre-polarization phase. The homogeneity of the DSV (207) is destroyed, but the field at the origin increases to 0.44T - a 4.4-fold enhancement - as more coil turns are now contributing positively to the total field. The stored energy of the magnet remains the same. There is a predominantly linear gradient in the pre-polarization field along the Z-axis, as shown in Figure 14, showing magnetic field data calculated over the same slice as Figure 13. This gives rise to a 28% variation in field intensity across the DSV 207 in a YZ slice; (an XZ slice is the same due to the axial symmetry of the magnet). This results in a similar variation in magnetization, which would ultimately manifest itself as a variation in signal strength, and hence image intensity, in an image taken in the XZ or YZ plane. This is not a particular problem and can be corrected by post-processing, but it should be noted that the variation in pre-polarization field across the DSV in the XY plane is very much smaller, only 0.03%, as shown in Figure 15. Imaging in the XY plan is therefore slightly preferred.

Generating an image in a slice through the DSV 207 requires that the magnet be held in the pre-polarization state for a time longer than about 3 to 5 times the longest spin-lattice (T1) time constant of interest in the sample. This allows magnetization to build to a significant fraction of its equilibrium value in the pre-polarization field. The field is then returned to the conventional read-out mode, by switching the currents back to their original direction. The duration of the field changeover is important, as discussed previously. A suitable imaging sequence of gradient and RF pulses is then applied, as will also be described in more detail later, and the NMR echo signals acquired are processed to form an image.

The simplest way to reverse the current in coils 201, 203 and 205 whilst leaving that in coils 202, 204 and 206 constant is to connect these coils as two distinct circuits and to arrange the magnet geometry so that they have very little mutual inductance. Alternative circuits are possible. The two "sub-magnets" thus formed can then be treated as electromagnetically isolated coils. If the mutual inductance (i.e.: coil coupling or flux linkage) is not close to zero the two sub-magnets would behave as a transformer, and switching current in one would affect the current in the other, which is clearly undesirable.

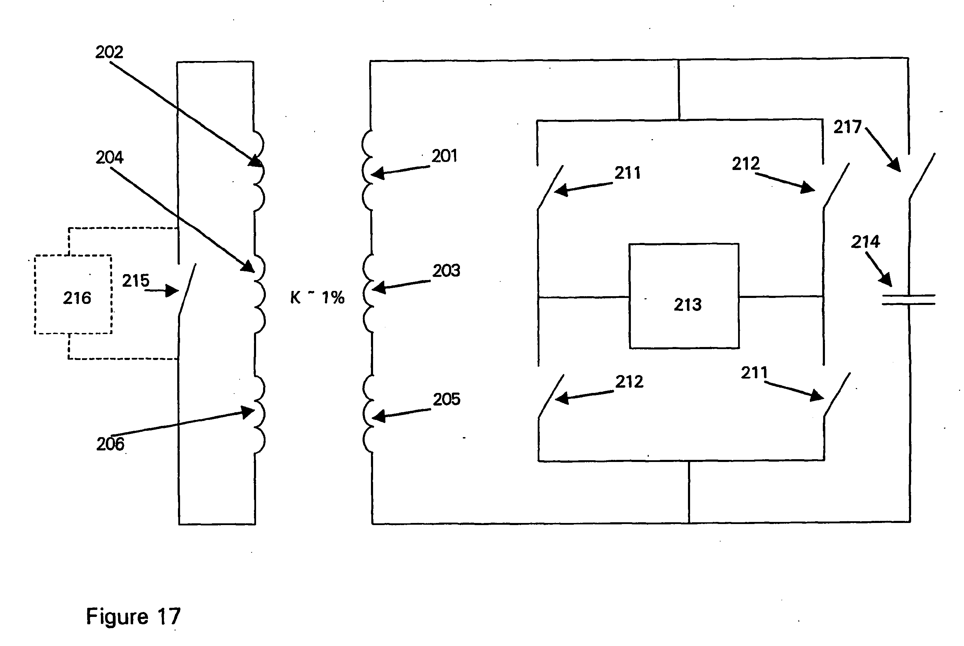

Creating near zero mutual inductance and homogeneous field from the same electromagnet magnet calls for careful design, but has been achieved in the example magnet shown in Figure 12 and Table 1. We shall denote the sub-magnet circuit that carries constant current the "constant-field sub-magnet" and the one that carries variable current the "variable-field sub-magnet". The variable-field sub-magnet is formed by connecting the odd-numbered coils in series, and the constant-field sub-magnet formed by connecting the even-numbered coils in series. A suitable circuit diagram is shown in Figure 17.

In Figure 17 superconducting coils 202, 204, and 206 are connected in series to form the constant-field sub-magnet. After energisation by the DC power supply (216), the superconducting switch (215) is closed and the power supply (216) may be removed. Current continues to flow in the constant field sub-magnet. A second DC power supply (213) is connected to the variable-field sub-magnet (coils 201, 203, and 205) by an H-bridge inverter (switch pairs 211 and 212). These switches may be solid state devices, such as IGBTs or relays. When switch pair 211 are closed current flows in the variable-field sub-magnet, generating the pre-polarization field. The current in the constant field sub-magnet is unaffected due to the low coupling (coupling coefficient K-1%) between the magnets. After allowing a sufficient duration (TP) for the magnetization of the sample to build up, switches 211 are opened. The energy stored by the coils 201, 203 and 205 keeps the current flowing and charges capacitor 214. The value of this capacitor is chosen so that it resonates with the self inductance of the variable field sub-magnet at the frequency defined by 1/TS, where TS is the desired field-switching time. For example, in the preferred 0.1T magnet, the inductance of the variable-field sub-magnet is 21.5 Henries. For a switching time of 100ms the capacitor 214 needs to be 47uF. When the current has fallen to zero (the stored energy has exchanged from the magnet to the capacitor), the switches 212 are closed. Current then increases through the variable field sub-magnet in the opposite direction until it reaches the same level as before, but flowing in the opposite direction. Most of the energy is supplied from the capacitor, with the power supply making up any small losses. Switch 217 is then opened (the current flowing through it having fallen to zero). After applying the imaging sequence, the current is again reversed by closing switch 217, opening switch pair 212, waiting until the current through the coils reaches zero, closing switch pair 211, waiting until the current through the coils reaches the peak value, then opening switch 217. This regenerative switching process may be repeated as often as required. Power supply 213 only needs to supply a small quantity of power to make up for any losses.

It is not a strict requirement to reverse the current to the same absolute level when flowing in the opposite direction - the correction coils could simply be turned off, or the current simply reduced. The former option would reduce the stored energy to 0.7MJ during the pre-magnetization period, but there would only a 2.7 fold enhancement in field and NMR signal. However, there are good technical reasons for preferring to have the current rise to the same absolute level but flowing in the opposite sense in the pre-polarization period compared to the read-out period: the stored energy in both pre-polarization and read-out modes with reversed but equal-magnitude current is the same, so choosing any lower current value means that energy will have to be removed, stored for the duration of the imaging sequence, which could be a few seconds, then added back into the magnet. This is inconvenient: 0 .1MJ of energy would have to be stored in the example above. Resonant switching of the current using a capacitor, as described above, is the most convenient way of rapidly reversing the current to the same value, and temporarily storing the energy in the capacitor bank during the short change-over period TS.

The MRI embodiment of the invention is therefore characterised by having at least two separate electrical circuits in the magnet. Embodiments with more than two separate circuits are also possible. However, it should be noted that both sub-magnets contribute to the properties of both the read-out field. This is in comparison to US-A-5835995 which uses separate magnets for generating the read-out and pre-polarization fields. Furthermore, as the relative physical positions of the windings elements of both sub-magnets are crucial in generating the homogeneous DSV in read-out mode, they should therefore be considered as sub-elements of the same magnet, rather than separate magnets.

As discussed before the pre-polarization technique requires that the magnetic field changes from pre-polarization to read-out mode according to the AFP criterion; i.e.: TS is shorter than the shortest T1 time constant of interest in the sample, but longer than the Larmor time constant of the nuclear species of interest. The field must also revert from pre-polarization mode to a stable read-out mode in less than a fraction of the shortest T2 time constant of materials of interest in the sample. Typical values for T1 and T2 in human tissues at 0.1T to 0.2T are in the range 200ms to 2 seconds. The Larmor frequency of the read-out field depends on the application and particular constraints of the design, but around 0.1T to 0.2T is probably close to optimal. This range corresponds to a Larmor frequency of about 4 to 8MHz for hydrogen, which is sufficiently high for 1/f noise to be negligible, but sufficiently low for the magnets stored energy to be manageable with a cost-effective design. The Larmor period of the readout field is therefore in the range 0.25us to 0.125us (eg: 1/4MHz = 0.25us). There is clearly no practical possibility that the field change will occur this fast, so T1 and T2 considerations dominate. The optimum field switch time (TS) is therefore in the range 50ms to 400ms, and the pre-polarization field should be on for 1 to 10 seconds (TP) for full magnetization. In some cases it may be preferred to use shorter TP times to create images with T1 contrast.

If the AFP criterion is met during the change from pre-polarization to read-out field, the enhanced magnetization built-up during the pre-polarization period is mostly retained during the read-out phase, leading to an increase in NMR signal proportional to the ratio of the pre-polarization to read-out field intensities. The orientation of the magnetic field during pre-polarization and read-out may be different, as the magnetization will track the changing field direction during AFP field changes. Different field vector orientations during the pre-polarization and measurement phases is not a requirement, and is not a feature of the preferred embodiment, but does allow more freedom in designing alternative magnet geometries. It should be noted that the transition time from read-out to pre-polarization field is not critical, and can be a longer duration if desired. In general, the read-out field needs to be stable during the measurement phase (pulse sequence) in common with conventional MR imaging. The stability of the pre-polarization field is less critical to image quality.

If the magnet were wound from copper wire according to Table 1 it would pose serious power consumption and heating problems. It is therefore strongly preferred to use superconducting magnets which consume negligible electrical power. Conventional superconducting wire is optimised for carrying DC current but would suffer from eddy currents losses during the change-over from pre-polarization to read-out mode. Modern high temperature superconductors (HTS) and wire construction methods offer great scope for overcoming this problem. Indeed, AC machines such as motors using HTS wire and HTS AC power cables have already been demonstrated. Therefore the preferred embodiment of the invention for the second category of applications uses AC-optimised HTS conductors for those coils with rapidly changing current.

The variable-field sub-magnet must be connected to a power supply or switches to allow its current to be varied and reversed as required. The constant-field sub-magnet must also be connected to a power supply for energisation, but if it is a persistent superconductor (i.e.: low temperature superconductor, LTS, such as NbSn or NbTi, or low-loss HTS) then it is preferred to close the circuit after energisation to form a closed superconducting loop. A superconducting switch is used to do this, as will be familiar to those versed in the art of LTS superconducting magnet design. The energisation power supply can then be removed and the current will continue to flow at a constant magnitude. If the mutual inductance to the variable field sub-magnet is low, as in the preferred example, the field switch-over will not significantly disturb the current in the closed-loop constant field circuit. A suitable circuit for the magnet is shown in Figure 17.

We can once again use stored energy calculations to highlight the advantage of the present invention over prior art. Taking the same 3m diameter 0.5T flat magnet described by Table 1., we can reduce the operating current by a factor of five to drop the read-out field to 0.1T. This reduces the stored energy from 20MJ to a manageable 0.8MJ. The switched-coil pre-polarization method and apparatus of the invention boosts the pre-polarization field strength, and hence NMR signal, by a factor of 4.4. The SNR of an MRI system depends on many factors, as previously discussed, several of which are a function of magnetic field strength. At this point a difference to the situation for bulk NMR measurement with well logging instruments must be noted. In a well logging measurement, the sensitive volume is smaller than the total sample volume (the fluid-filled porous rocks surrounding the tool), however in an MRI system the sample is generally smaller than the sensitive volume. In the latter case the sample volume must be made large enough to contain the sample to be imaged, such as a head, limb joint, or portion of spinal column. Unlike a well logging tool, the SV size is therefore determined by sample geometry and is not a parameter which the designer may significantly adjust.

An analysis of the embodiment using the SNR equations presented in "The Signal-to-Noise ratio of the NMR experiment", Hoult & Richards, J. Mag. Res. Vol. 24, 71-85, 1976 and in oThe Intrinsic Signal-to-Noise Ratio in NMR Imaging", Edelstein et al, Magnetic Resonance in Medicine, 3, 604-618 (1986) shows that, to a good approximation, the 0.1T flat magnet of this exemplary embodiment will produce images of the similar quality to a 0.5T flat magnet. However the 0.5T flat magnet stores 20MJ, compared to 0.8MJ in the 0.1T flat magnet with pre-polarization, and about 0.2MJ in a 0.5T simple solenoid. Clearly the present invention represents a very significant step in reducing the engineering difficulty associated with this type of open-access magnet. The same arguments apply for all types of open access magnets, for example the shaded pole design shown in US-A-4689591 and the version with a dish-shaped SV described in US-A-5331282, because all open external-field magnets demonstrate poor gauss/amp efficiency compared to their internal-field equivalents, and all will benefit from pre-polarization as implemented in this invention.

Additional hardware elements are required to create an image of a sample placed in the SV. Firstly, one or more radio-frequency antennas will be required to transmit RF pulses at the Larmor frequency and receive NMR signals. The RF oscillating magnetic field transmitted to excite the nuclei in the SV must be orthogonal to the read-out static magnetic field. There are a number of coil geometries which will achieve this that will be apparent to the skilled user, some examples of which that suit the magnet of Figure 11 are now given by way of example. However, this list is by no means exhaustive. A single RF surface coil predominantly in the XZ or YZ plane producing RF field oriented along the X or Y axis may be used. Such a coil would typically be optimised to suit the particular characteristics of the sample (i.e.: body part specific). The same coil could be used for receiving the NMR signals, with a suitable transmit/receive switch. Alternatively, separate orthogonal, non-coupling surface coils may be used for transmit and receive, or they may be connected in quadrature to create a rotating field in transmit mode, generating quadrature signals in receive mode, resulting in a root-2 improvement in SNR.

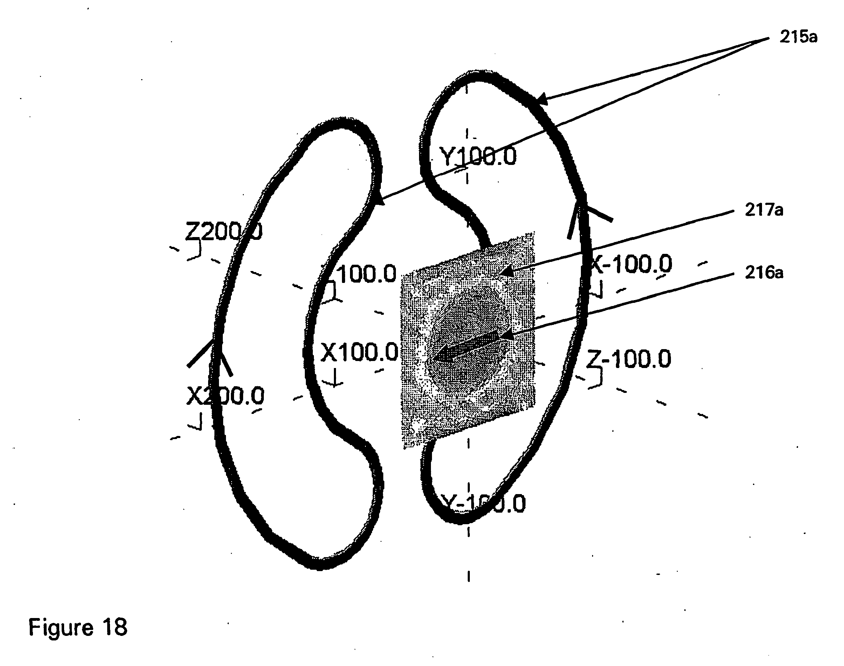

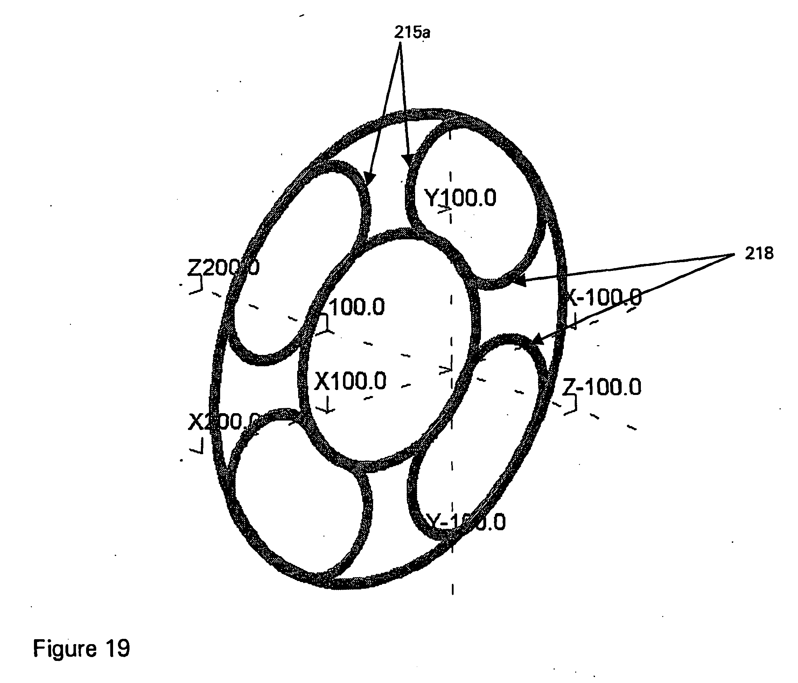

If it is desired to keep the RF system in the same plane as the magnet, for example to preserve the hardware as a truly one-sided imaging system, then gradiometer RF coils are suitable. Simple examples are shown in Figures 18 and 19.

Figure 18 shows an RF gradiometer coil (215a) in the XY plane, generating RF magnetic field in the X direction (216a). The arrows indicate the current direction. Although not shown, the coils are connected in series. This coil is a modified version of one coil of pair of "butterfly coilso shown in Figure 10. The modification to separate kidney shaped coils connected in series with the correct orientation produces a similar RF magnetic field distribution to one coil of Figure 10, but allows access though the centre of the coils. In the one-sided imaging system embodiment being described this hole would allow a patient to position a limb perpendicular to the plane of the magnet, thus passing through the hole in the centre of the magnet and though the modified RF and gradient coils (the latter yet to be described). The magnet cryostat would also have to incorporate a suitable hole. This feature affords an extra degree of freedom to orient the imaging subject within the MRI system field of view (FOV). Whilst useful, this is not an essential feature of the embodiment and the original design of butterfly RF coils (or similar) could be employed. Contour plot 217a shows the RF field X component magnitude variation over a 200mm x 200mm XY slice though the DSV. The variation in the X component of RF flux density is sufficiently uniform (i.e. : the variation in spin tip angle for a notionally 90 degree pulse is not more than 45 degrees).

Figure 19 shows a second RF coil (218) placed on top of the first (215a). In this arrangement the coils display near zero flux coupling, and act as an orthogonal pair, analogous to the butterfly coils of Figure 10. One coil may be used for transmitting RF pulses and the other for receiving NMR signals. As will be clear to those versed in the art, the X-coils can be used for transmit (Tx) and the Y-coils for receive (Rx), or vice versa, or both coils can be connected in quadrature and used for both Rx and Tx, with a root-2 increase in SNR and root-2 reduction in RF power respectively, using suitable electronics. These coils lie in the XY plane in front of the magnet, close to the sample. They are shown as closed loops, but in practice are connected in series in the correct orientation to generate RF fields in the X or Y direction.

A useful property of the gradiometer coils shown in Figures 10, 18 and 19 is their selective sensitivity. They are only sensitive to RF magnetic field signals generated in their immediate vicinity. Plane waves, as would arrive from a distant source unrelated to the imaging apparatus or sample, induce equal and opposite voltages in the two halves of the coil, resulting in no net signal. Gradiometer coils of this type therefore reject interference from far field sources in favour of the local NMR signal. More information can be obtained from Seton et al (Meas. Sci. Tech. Vol. 8, 198-207, 1997).

If conventional MRI pulse sequences are to be used gradient coils will be required to encode the NMR signal in k-space (frequency-phase), as will be familiar to those skilled in the art.

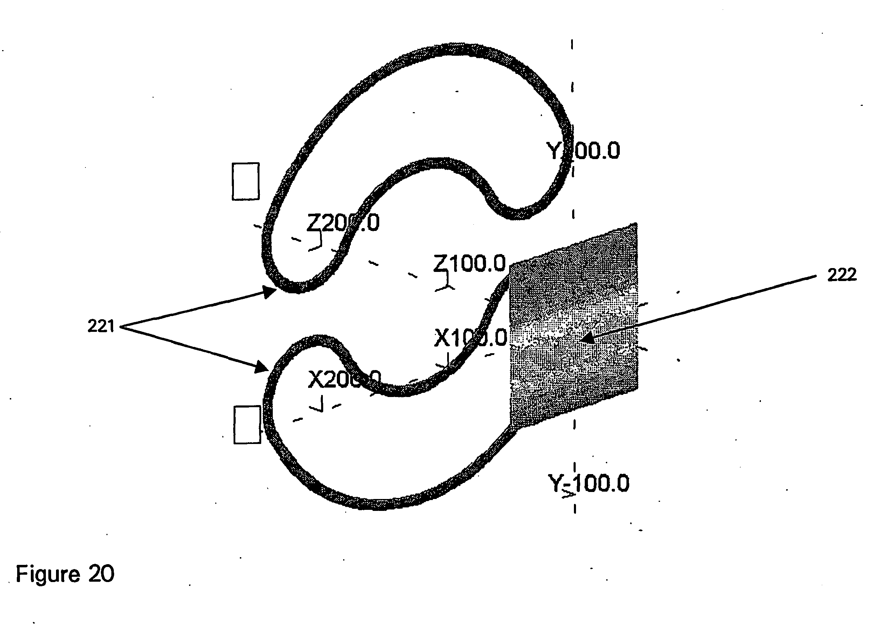

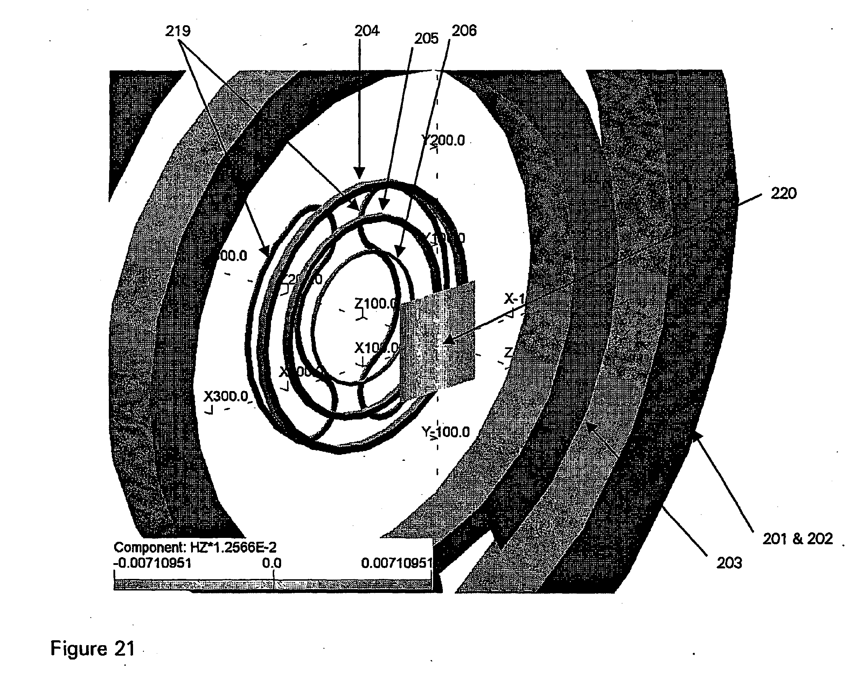

If gradient coils are to be used, there are many options available, suiting different applications. If it is desired to keep all of the imaging hardware in the plane of the magnet, then it is possible to design gradient coils that also lie in the plane of the magnet and produce the required gradient magnetic fields (i.e.: with field oriented along the Z axis and gradients in the X and Y directions, i.e.: dBz/dx and dBz/dy). Simple examples are shown in Figures 20 and 21. The coils in this example have essentially the same geometry as the RF coils.

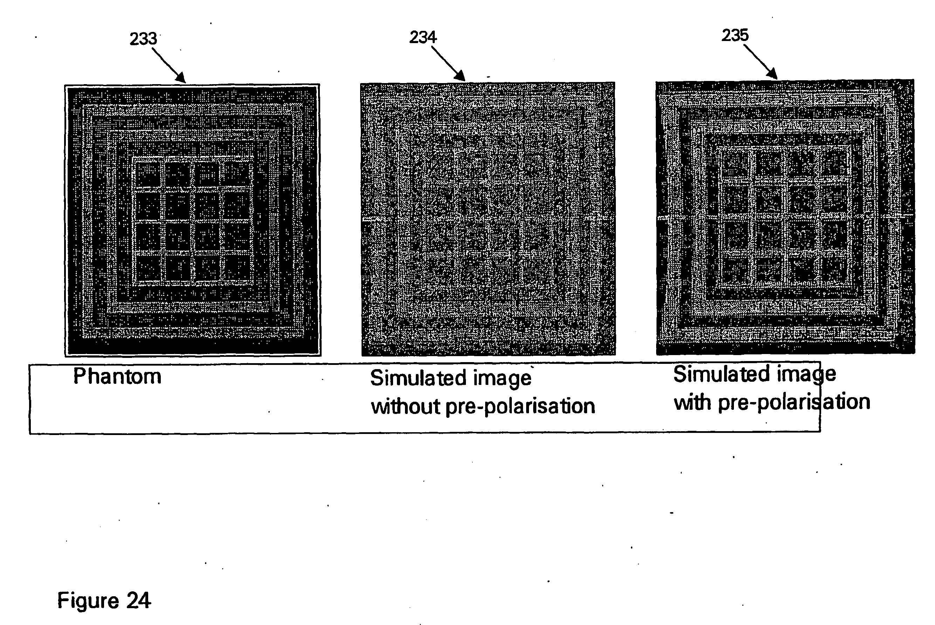

Figure 20 shows a Y gradient coil (221) in the XY plane. The currents flow in the same sense in the two halves as in the RF coil (215a) shown in Figure 18. A contour plot of the gradient field (the Z component of B0) across a 20cm x 20cm XY slice though the DSV (207) is shown (222). It should be noted that the flat gradients are "impure". In other words, they do not generate magnetic field purely in the Z direction. The X gradient coils generate a vector field with a component in the X direction, and the Y gradient coils generate a vector field with a component in the Y direction (this field component is actually used when he same geometry coils are utilised as RF coils). A consideration of the physics of NMR will demonstrate that the field components orthogonal to the static B0 field have only a small effect on the image. In the exemplary embodiment described here, the X and Y gradient coils generate gradient fields with gradients typically 0.2 Gauss/cm. In a typical imaging sequence the magnitude of the orthogonal (X or Y) field component generated by the gradient coil is about 3.6G at the centre of the DSV (where it is strongest). This combines in vector fashion with the B0 field, which is 1000 Gauss (0.1T) in read-out mode to create an effective field of 1000.006G at an angle of 0.2 degrees to the Z-axis. This tiny change amounts to a frequency offset in the echo of 25Hz, which is well within the Rx bandwidth (21kHz in this example). The only noticeable effect is a slight distortion of the image in the "frequency encode direction" (Y in this example), as can be seen in Figure 24.

Figure 21 shows an X gradient coil (219) in the XY planes showing its location in relation to the magnet coils (201 to 206). A contour plot of the gradient field across a 20cm x 20cm XY slice though the DSV (207) is shown (220), demonstrating the linearity of the gradient field across the slice. Note that the gradient coil arrangement shown has a 400mm diameter access hole through the middle. As with the RF coils this allows the patients head or limbs to be positioned along the Z-axis for imaging of joints, etc. the through-access ability is not a necessity. As with the RF coils in Figures 18 and 19, these gradient coil examples have near zero mutual inductance between the X and Y gradient coils, which is advantageous for easy gradient switching circuit design. These flat gradient coil designs are amenable to optimisation for efficiency and gradient linearity by means of algorithms which calculate the required current distribution from the desired field profile, as will be familiar to those skilled in the art. The same technique can be applied to the RF coil design.

Alternatively the flat gradient coils may be placed in the XZ or YZ planes orthogonal to the magnet. These may be most suited to imaging of limbs or the head and the flat coils may be placed under the sample support means (e.g.: patient bed). Suitable flat coils for this orientation are described by Cho and Yi (J. Mag. Res, Vol. 94, 471-485, 1991).

In accordance with conventional techniques, image information is encoded into spin-echoes generated by any of a variety of RF and gradient pulse sequences that will be familiar to those skilled in the art. An exemplary spin-warp pulse sequence is described in more detail in the next section. The image is typically reconstructed from the echo data by Fourier Transformation, except in the case of rotating frame imaging, which requires a statistical technique.

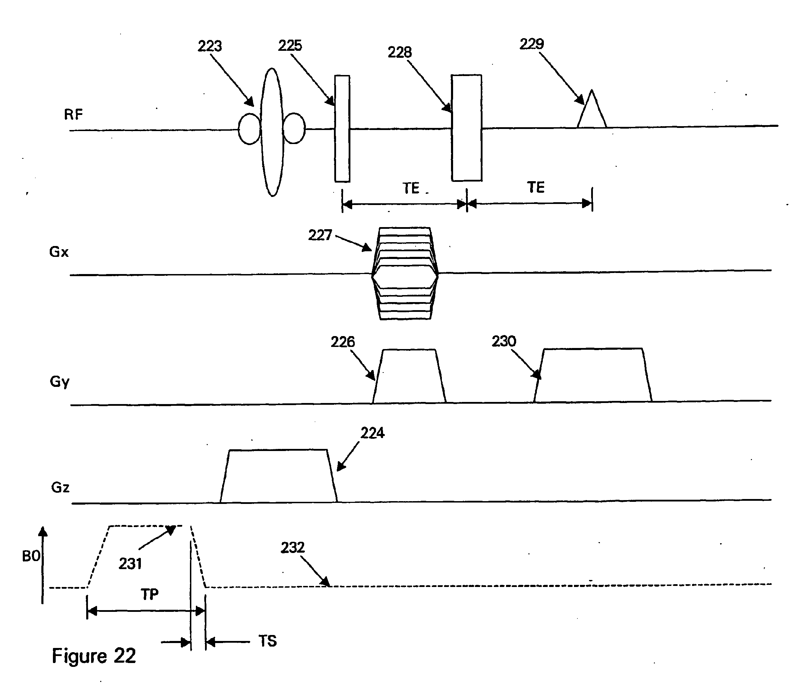

Figure 22 shows a typical spin-warp imaging pulse sequence for generating images in the XY plane. The pre-polarization field (231) is applied for time TP (equivalent to 3 to 5 times the longest T1 of interest in the sample for full magnetization enhancement). The field is then switched to the read-out mode (232). Next a slice selection RF pulse (223) is applied in the presence of a Z-gradient (224, Gx = dBz/dz), to invert the spins in the selected slice and scramble the magnetization outside the slice. This gradient may be generated by suitable gradients coils (like the Cho and Yi variety) or using the gradient of the pre-polarization field, as described above. A tipping pulse (225) is applied followed by a frequency encoding gradient pulse (226) from the Y axis gradient coil (Gy = dBz/dy), and a phase encoding gradient pulse (227) from the X axis gradient coil (Gx = dBz/dx). At time TE after the tipping pulse a re-focusing pulse (228) reverses the phase dispersion, causing an echo (229) to form after a further time TE. A read-out Y gradient (230) is applied during the echo acquisition to frequency encode the data. The echo contains data for one image line in k-space. The BO field is then returned to the pre-polarization value, and the imaging sequence is repeated with the amplitude of the X gradient incremented. This is repeated a number of times to build up the 2D k-space image data. This data set is subsequently Fourier transformed to generate the real space image. Many alternative imaging sequences are possible, as will be apparent to those skilled in the art.

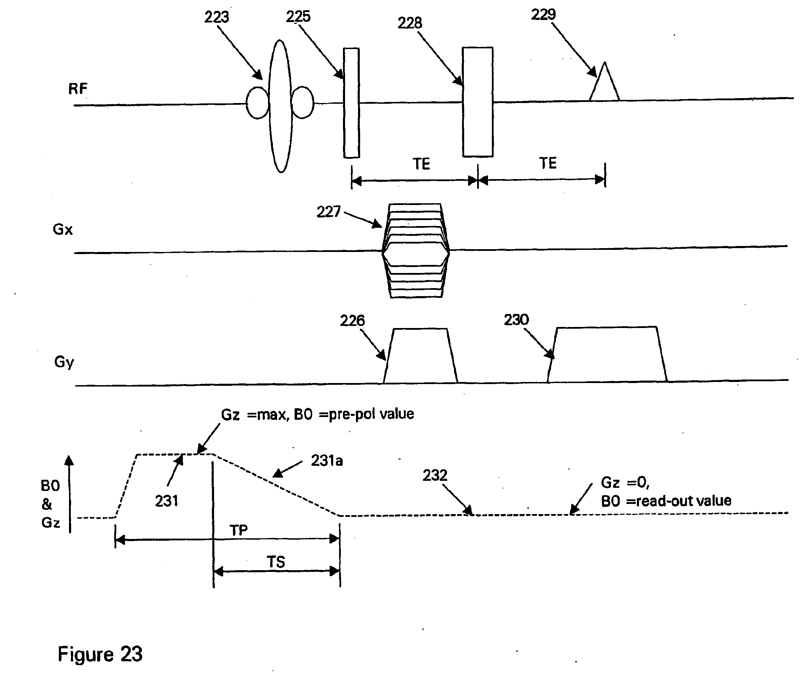

It should be noted that to create images in the XY plane using flat X and Y gradient coils in the same plane, as shown in Figures 20 and 21, a separate slice selection Z-gradient coil is not a necessity. By applying a slice selective RF pulse during the transition from pre-polarization to read-out field, the magnetization in the DSV (207) can be encoded to preserve information from a slice in the XY plane for read-out using X and Y gradients. As shown in Figure 23 this is achieved by applying a 180 degree slice selection pulse 223 (the amplitude envelope of which is shaped to select a slice with a "top hat" profile in the Z direction) during the transition from pre-polarization to read-out field 231a. If the pulse is applied at the right moment, the decreasing Z-gradient in the B0 field will set the correct slice thickness. The 180 degree slice selection pulse inverts magnetization within the slice. Magnetization that is aligned parallel or antiparallel to the magnetic field experiences no torque, so that the magnetization within the slice that was inverted by the slice-selection pulse remains unaffected by the continuing B0 field transition. However magnetization outside the slice will have been rotated by more or less than 180 degree and will therefore experience a torque in the changing B0 field. The magnetization outside the slice precesses at different rates whilst the field change-over occurs and is randomly oriented by the time the B0 field stabilises at the read-out value. The scrambled magnetization outside the selected slice does not contribute in a coherent manner to the NMR signals generated by subsequent measurement pulse sequences. The pulse sequence then proceeds in the same manner as the standard spin-warp sequence previously described. The method described here requires that the transmit antenna is capable of transmitting high power RF pulses at the Larmor frequency at the Z-position of the slice at the time when the slice-selection pulse is applied. This will be a higher frequency than the read-out frequency, because the B0 field strength is higher at that time than the read-out value. This can be achieved ether by using a separate transmit antenna tuned to the higher frequency for the slice-selection pulse, or using a double-tuned antenna, as will be familiar to those skilled in the art.

Figure 24 shows a pair of simulated images generated using NMR spin simulation software. Magnetic field data generated from analytical models of the apparatus described in Figures 11 to 22, and the pulse sequence of Figure 23 form the input to the simulation, which solves the Bloch equations numerically. Simulated NMR echoes are output, which are then Fourier Transformed to create an image. The test sample ("phantom") is placed in the 20cm x 20cm slice in the XY plane at the centre of the DSV. The phantom (233) consists of a "cheese-cutter" grid with 5mm thick walls, surrounded by two square section tubes, all oriented along the Z-axis. The spin density in the sample is 100%, and 0% elsewhere. The slice thickness in Z is 5mm. Image (234) was acquired using conventional prior-art imaging methods without pre-polarization (i.e.: in a constant 0.1T field). Thermal noise of a realistic amplitude was added to the simulated echo data, and 32 data sets were accumulated to improve SNR. Clearly the simulated image (234) displays poor SNR. Some artefacts are also visible: the "zipper" artefact across the centre is caused by a data collection error and can be ignored, whilst the distortion is due to impurity in the read-out Y-gradient field, as previously discussed. Image (235) was taken with the pre-polarization enhancement method and apparatus of the invention, thus demonstrating the significant SNR and image quality improvement possible.

It may be advantageous in many applications to cryogenically cool the RF and/or the gradient coils, or even to make these from superconducting wire, typically HTS, to further increase SNR as described above. In the case of the examples of RF and gradient coils that lie in the XY plane as the magnet, (as shown in Figures 20 and 21), these coils may be fitted inside the magnet cryostat. This would require that the cryostat has a window made from non-metallic, non-conducting material to allow the time varying RF and gradient fields to pass through the cryostat walls. A suitable material is fibreglass. An RF transparent cryostat is described by Seton et al. Non-metallic cryostats will probably suffer from lower efficiency compared to conventional cryostats, but this is less of a problem if HTS materials are used, particularly if the magnet only needs cooling to liquid nitrogen temperature, as is promised by the next generation of HTS wire.

Superconducting magnets require cooling below the transition temperature of the superconducting material. This is 4 degrees Kelvin in the case of liquid helium, but the next generation of HTS materials promise to have far higher transition temperatures. Embodiments utilising HTS magnets could advantageously use mechanical cryo-coolers and do without baths of liquid cryogen. Without the constraint of a liquid He bath, a smaller-scale open access magnet could be easily moved into position around a stationary patient, with obvious advantages for body-part imaging applications where it is desirable not to move the patient, such as during surgery.

The embodiment for MR imaging described above uses electromagnets as the generators of magnetic field. It is not intended to limit embodiments of the invention for MR imaging to only electromagnets. A contribution to the time-invariant field produced by the constant-field sub-magnet could be generated by one or more permanent magnets, with the remainder of the constant-field being made up by an electromagnet, and the variable-field sub-magnet being an electromagnet. The electromagnets provide the balance of the fields and have the necessary field gradients to cancel inhomogeneity in the contribution from the permanent magnet in read-out mode. The current in the electromagnet is reversed to boost the total field strength in pre-polarization mode. The use of a permanent magnet to boost the field reduces the current required in the electromagnets. Combined with an iron yoke, this could allow the invention to be embodied on a small scale with resistive electromagnets operating at acceptable power output. In such an embodiment a soft iron yoke would reduce the size of the stray field envelope.

A disadvantage of the flat magnet embodiment shown in Figure 12 and Table 1 is that its stray magnetic field footprint (the 0.5 mT (5 Gauss) limit within which persons with pacemakers and electronic media are traditionally excluded for safety reasons) will expand (or obloom") during the pre-polarization mode. One way to stop stray-field bloom would be to incorporate a switched active shield coil. This would add one extra coil surrounding the mail magnet coils. The shield coil would be de-energized in read-out mode and energized in pre-polarization mode. The coil geometry of the extra coil is chosen so that its magnetic moment is equal and opposite to the combined magnetic moment of the other coils in pre-polarization mode, but it has minimum effect on the pre-polarization field strength. The shield coil would be ideally be driven from its own power supply as it would couple weakly to both the variable and the static sub-magnets.

Although the embodiments describe primarily "flat" magnets, the invention is applicable to other external field assemblies, for example to bowl shaped assemblies with the sensitive or working volume partially inside the bowl.

## Claims

1. A magnetic field generating assembly comprising a magnetic field generation system including first and second magnetic field generators (7,8,13) for generating respective, static magnetic fields; and a control system; the magnetic field generation system being arranged to generate, in a first mode, a first, relatively strong static magnetic field in a working volume located outside the assembly, and to generate, in a second mode, a second, static magnetic field in the working volume, wherein the control system is arranged to control the second magnetic field generator such that in the first mode the two magnetic field generators (7,8,13) generate magnetic fields in the same sense to generate the first relatively strong magnetic field in the working volume, and such that in the second mode the two magnetic field generators (7,8,13) generate magnetic fields in opposite senses such that the resultant magnetic field in the working volume is weaker but more uniform than the relatively strong magnetic field, to enable a magnetic resonance process on a sample in the working region to be performed.

2. An assembly according to claim 1, wherein the second magnetic field generator comprises an electromagnet (201,203,205).

3. An assembly according to any one of the preceding claims, wherein the first magnetic field generator comprises an electromagnet (202,204,206).

4. An assembly according to claim 2 and claim 3, in which the positions and turns-density of the winding elements comprising the first and second electromagnets (201-205) are chosen so that the mutual inductance between the first and second electromagnets is close to zero.

5. An assembly according to claim 2 and claim 3, or claim 5, in which the two electromagnets (201-206) are substantially co-planar with interleaved winding sections.

6. An assembly according to any of claims 2 to 5, in which the electromagnets (201-206) are cryogenically cooled.

7. An assembly according to claim 6, in which the cooled electromagnets (201-206) are superconducting.

8. An assembly according to claim 7, in which the superconducting electromagnets are fabricated from high temperature superconductor.

9. An assembly according to claim 8, in which the electromagnet of the second magnetic field generator utilises high temperature superconducting wire optimised for high rate of change of current.

10. An assembly according to claim 1, wherein the first and second magnetic field generators comprise a plurality of permanent magnets (7,8,13), the magnets being physically movable with respect to each other to change the magnetic field intensity and uniformity in the working volume.

11. An assembly according to claim 10, wherein the first and second magnetic field generators consist of a pair (8a,9a) of radially magnetised, substantially cylindrical magnets, one being located within the other, whereby said pair radially magnetised magnets are relatively rotatable.

12. An assembly according to claim 11, wherein the pair of magnets are concentric.

13. An assembly according to claim 10, wherein the magnets (8,13) are arranged side by side, at least one being movable with respect to the other(s) to reverse its direction of magnetisation.

14. An assembly according to claim 1, wherein the magnetic field generators comprise one or more main magnets (7) and at least two shim magnets (8,13) at least one of the shim magnets being adjustable relative to the other to achieve the first and second conditions.

15. An assembly according to claim 14, wherein the main magnets (7) are oriented so that their magnetisation directions extend at an acute angle to the magnetisation directions of the shim magnets.

16. An assembly according to any one of claims 10 to 15, further comprising means for moving the magnetic field generators, the means comprising one of an electromagnetic actuator, hydraulic actuator, pneumatic actuator, piezoelectric actuator, or a mechanical actuator such as a spring, gears, levers, thermal expansion or contraction, and memory metal.

17. An assembly according to any one of claims 10 to 16, in which the magnetic field generators (7,8,13) are permanent rare earth magnets.

18. An assembly according to any one of the preceding claims, surrounded by a switched shield coil that is de-energized in the second but energized in the first mode so that it has magnetic moment substantially equal and opposite to the combined magnetic moment of the first and second magnetic field generators in the first mode.

19. Apparatus for generating a tomographic MRI image of a subject, the apparatus comprising a magnetic field generating assembly according to any one of the preceding claims, the subject being located in the working volume in use; signal excitation and detecting apparatus for applying a pulse of oscillating magnetic field at the Larmor frequency of the nuclei of material of interest in the working volume, the oscillating field being substantially orthogonal to the static magnetic field, and for receiving NMR signals from the excited nuclei; gradient coils to encode the NMR signal in k-space; and a system to record and process the signals into an image.

20. Apparatus according to claim 19, when dependent on claim 5, in which the gradient coils are planar coils mounted in substantially the same plane as the electromagnets.

21. Apparatus according to claim 19, when dependent on claim 5, in which the gradient coils are planar coils mounted in the plane orthogonal to the plane of the electromagnets .

22. Apparatus according to any one of claims 19 to 21, further comprising a coolant system for cryogenically cooling the gradient coils.

23. Apparatus according to any one of claims 19 to 22, wherein the signal excitation and detecting apparatus comprises a radio frequency antenna to generate pulses of oscillating magnetic field at the subject's Larmor resonant frequency orthogonal to the static magnetic field during the second mode; and a radio frequency antenna to detect NMR signals from the sample during the second mode.

24. Apparatus according to claim 23, wherein the RF antennas comprise orthogonal RF coils.

25. Apparatus according to claim 23 or claim 24, wherein the antennae comprise a RF coil which may be surface mounted on the subject in use.

26. Apparatus according to any one of claims 23 to 25, when dependent on claim 5, wherein the antennae comprise a RF coil mounted in substantially the same plane as the electromagnets.

27. Apparatus according to any one of claims 24 to 26, wherein the RF antennae are cryogenically cooled.

28. Apparatus according to any one of claims 24 to 27, wherein the RF antennae are superconducting.

29. Apparatus according to any one of claims 19 to 28, when dependent on claim 17, in which a layer of soft ferrite is placed within an antenna winding of the signal excitation and detecting apparatus or between the majority of the antenna conductors and the conducting parts of the tool.

30. Apparatus according to claim 29, in which the ferrite layer is made from a number of elements to prevent dimensional resonances.

31. Apparatus according to any one of claims 19 to 30, wherein the magnetic field generators and the signal excitation and detecting apparatus are mounted on a support for movement between first and second positions relative to the region of interest and corresponding to the first and second modes respectively.

32. Apparatus according to claim 31, wherein the magnetic field generators and the signal excitation and detecting apparatus are mounted at fixed locations relative to each other on the support.

33. A method for obtaining NMR information about a sample, the method comprising:
(i) operating a magnetic field generating assembly including first and second magnetic field generators (7,8,13) such that both generate magnetic fields in the same sense to apply a relatively strong, generally non-uniform static magnetic field in a working volume located outside the assembly and containing a sample, for a duration longer than the longest spin-lattice (T1) relaxation time of the material of interest in the sample to allow enhanced magnetization to build up in the sample;
(ii) operating the first and second magnetic field generators (7,8,13) to generate magnetic fields in opposite senses to apply a weaker but much more uniform static magnetic field across said working volume, the change in static magnetic field occurring in a time shorter than the shortest spin-spin (T2) relaxation time of the material of interest in the sample, but longer than the Larmor period;
(iii) applying a suitable sequence of radio frequency pulses to generate NMR signals;
(iv) detecting and recording the NMR signals; and
(v) processing the recorded data.

34. A method according to claim 33 for measuring bulk NMR properties of the sample, wherein step (v) further comprises processing the recorded data to calculate bulk NMR properties.

35. A method according to claim 33 for obtaining NMR information about a subject wherein step (iii) further comprises applying switched magnetic gradient field pulses to encode the image information in the NMR signals, step (v) comprising processing the recorded data to form an image of the subject.

36. A method according to claim 35, in which the imaging subject is a limb or other in-vivo body part containing tissue with non-isotropic NMR properties, such as a tendon or ligament.

37. A method according to claim 36, in which the non-isotropic tissue in the body part is oriented at the "magic angle" to the static field direction.

38. A method according to any one of claims 35 to 37, in which the location of two dimensional tomographic images is selected by applying an amplitude modulated inversion RF pulse during the transition from the first to second field states.

39. A method according to any one of claims 33 to 38, wherein the magnetic field generating assembly is constructed in accordance with any of claims 1 to 18.

## Patentansprüche

1. Magnetfeld-Erzeugungsanordnung, die ein Magnetfeld-Erzeugungssystem umfasst, das eine erste und eine zweite Magnetfeld-Erzeugungseinrichtung (7, 8,13) zum Erzeugen jeweiliger statischer Magnetfelder und ein Steuerungssystem umfasst, wobei das Magnetfeld-Erzeugungssystem so eingerichtet ist, dass es in einem ersten Modus ein erstes, relativ starkes statisches Magnetfeld in einem Arbeitsvolumen erzeugt, das sich außerhalb der Anordnung befindet, und in einem zweiten Modus ein zweites statisches Magnetfeld in dem Arbeitsvolumen erzeugt, wobei das Steuerungssystem so eingerichtet ist, dass es die zweite Magnetfeld-Erzeugungseinrichtung so steuert, dass in dem ersten Modus die zwei Magnetfeld-Erzeugungseinrichtungen (7, 8, 13) Magnetfelder in der gleichen Richtung erzeugen, um das erste, relativ starke Magnetfeld in dem Arbeitsvolumen zu erzeugen und so, dass in dem zweiten Modus die zwei Magnetfeld-Erzeugungseinrichtungen (7, 8, 13) Magnetfelder in einander entgegengesetzten Richtungen erzeugen, so dass das resultierende Magnetfeld in dem Arbeitsvolumen schwächer, jedoch gleichmäßiger ist als das relativ starke Magnetfeld, um zu ermöglichen, dass ein Magnetresonanzverfahren an einer Probe in dem Arbeitsbereich durchgeführt wird.

2. Anordnung nach Anspruch 1, wobei die zweite Magnetfeld-Erzeugungseinrichtung einen Elektromagneten (201, 203, 205) umfasst.

3. Anordnung nach einem der vorangehenden Ansprüche, wobei die erste Magnetfeld-Erzeugungseinrichtung einen Elektromagneten (202, 204, 206) umfasst.

4. Anordnung nach Anspruch 2 und Anspruch 3, wobei die Positionen und Windungsdichten der Wicklungselemente, die den ersten und den zweiten Elektromagneten (201-205) bilden, so gewählt werden, dass die wechselseitige Induktanz zwischen dem ersten und dem zweiten Elektromagneten nahe bei Null liegt.

5. Anordnung nach Anspruch 2 und Anspruch 3 oder Anspruch 5, wobei die zwei Elektromagneten (201-206) im Wesentlichen koplanar mit überlappenden Wicklungsabschnitten sind.

6. Anordnung nach einem der Ansprüche 2 bis 5, wobei die Elektromagneten (201-206) kryogen gekühlt werden.

7. Anordnung nach Anspruch 6, wobei die gekühlten Elektromagneten (201-206) supraleitend sind.

8. Anordnung nach Anspruch 7, wobei die supraleitenden Elektromagneten aus Hochtemperatur-Supraleiter hergestellt sind.

9. Anordnung nach Anspruch 8, wobei der Elektromagnet der zweiten Magnetfeld-Erzeugungseinrichtung Hochtemperatur-Supraleitdraht verwendet, der für eine hohe Geschwindigkeit der Stromänderung optimiert ist.

10. Anordnung nach Anspruch 1, wobei die erste und die zweite Magnetfeld-Erzeugungseinrichtung eine Vielzahl von Permanentmagneten (7, 8, 13) umfassen und die Magnete in Bezug zueinander physisch bewegt werden können, um die Intensität und Gleichmäßigkeit des Magnetfeldes in dem Arbeitsvolumen zu ändern.

11. Anordnung nach Anspruch 10, wobei die erste und die zweite Magnetfeld-Erzeugungseinrichtung aus einem Paar (8a, 9a) radial magnetisierter, im Wesentlichen zylindrischer Magneten bestehen, von denen sich einer in dem anderen befindet, und das Paar radial magnetisierter Magneten relativ zueinander gedreht werden kann.

12. Anordnung nach Anspruch 11, wobei die paarigen Magnete konzentrisch sind.

13. Anordnung nach Anspruch 10, wobei die Magnete (8, 13) nebeneinander angeordnet sind und wenigstens einer in Bezug auf den anderen bewegt werden kann, um seine Magnetisierungsrichtung umzukehren.

14. Anordnung nach Anspruch 1, wobei die Magnetfeld-Erzeugungseinrichtungen einen oder mehrere Hauptmagnete (7) und wenigstens zwei Einstell-Magnete (shim magnets) (8, 13) umfassen und wenigstens einer der Einstell-Magnete relativ zu dem anderen verstellt werden kann, um den ersten und den zweiten Zustand herzustellen.

15. Anordnung nach Anspruch 14, wobei die Hauptmagnete (7) so ausgerichtet sind, dass sich ihre Magnetisierungsrichtungen in einem spitzen Winkel zu den Magnetisierungsrichtungen der Einstellmagnete erstrecken.

16. Anordnung nach einem der Ansprüche 10 bis 15, die des Weiteren eine Einrichtung zum Bewegen der Magnetfeld-Erzeugungseinrichtungen umfasst, wobei die Einrichtung ein elektromagnetisches Betätigungselement, ein hydraulisches Betätigungselement, ein pneumatisches Betätigungselement, ein piezoelektrisches Betätigungselement oder ein mechanisches Betätigungselement, wie beispielsweise eine Feder, Zahnräder, Hebel, Wärmeausdehnung oder -zusammenziehung und Nano-Metall umfasst.

17. Anordnung nach einem der Ansprüche 10 bis 16, wobei die Magnetfeld-Erzeugungseinrichtungen (7, 8, 13) Seltenerd-Permanentmagnete sind.

18. Anordnung nach einem der vorangehenden Ansprüche, die von einer Schalt-Abschirmspule umgeben ist, die in dem zweiten Modus enterregt, im ersten Modus jedoch erregt ist, so dass sie Magnetmoment aufweiset, das im Wesentlichen dem kombinierten Magnetmoment der ersten und der zweiten Magnetfeld-Erzeugungseinrichtung in dem ersten Modus entspricht und ihm entgegengesetzt ist.

19. Vorrichtung zum Erzeugen eines tomografischen MRI-Bildes eines Objektes, wobei die Vorrichtung eine Magnetfeld-Erzeugungsanordnung nach einem der vorangehenden Ansprüche umfasst und sich das Objekt in Funktion in dem Arbeitsvolumen befindet; eine Signai-Erregungs-und-Erfassungs-Vorrichtung zum Anlegen eines Impulses eines oszillierenden Magnetfeldes auf der Larmor-Frequenz der Kerne des interessierenden Materials in dem Arbeitsvolumen umfasst, wobei das oszillierende Feld im Wesentlichen senkrecht zu dem statischen Magnetfeld ist, sowie zum Empfangen von NMR-Signalen von den erregten Kernen, Gradientenspulen zum Kodieren des NMR-Signals im k-Raum und ein System zum Aufzeichnen sowie Verarbeiten der Signale zu einem Bild umfasst.

20. Vorrichtung nach Anspruch 19, wenn abhängig von Anspruch 5, wobei die GradientenSpulen plane Spulen sind, die im Wesentlichen in der gleichen Ebene angebracht sind wie die Elektromagneten.

21. Vorrichtung nach Anspruch 19, wenn abhängig von Anspruch 5, wobei die Gradientenspulen plane Spulen sind, die in der Ebene senkrecht zu der Ebene der Elektromagneten angebracht sind.

22. Vorrichtung nach einem der Ansprüche 19 bis 21, die des Weiteren ein Kühlmittelsystem zum kryogenen Kühlen der Gradientenspulen umfasst.

23. Vorrichtung nach einem der Ansprüche 19 bis 22, wobei die Signal-Erregungs-und-Erfassungs-Vorrichtung eine Funkfrequenzantenne zum Erzeugen von Impulsen eines oszillierenden Magnetfeldes bei der Larmor-Resonanzfrequenz des Objektes senkrecht zu dem statischen Magnetfeld während des zweiten Modus sowie eine Funkfrequenzantenne zum Erfassen von NMR-Signalen von der Probe während des zweiten Modus umfasst.

24. Vorrichtung nach Anspruch 23, wobei die HF-Antennen orthogonale HF-Spulen umfassen.

25. Vorrichtung nach Anspruch 25 oder Anspruch 24, wobei die Antennen eine HF-Spule umfassen, die in Funktion an dem Objekt oberflächenmontiert werden kann.

26. Vorrichtung nach einem der Ansprüche 23 bis 25, wenn abhängig von Anspruch 5, wobei die Antennen eine HF-Spule umfassen, die im Wesentlichen in der gleichen Ebene angebracht ist wie die Elektromagneten.

27. Vorrichtung nach einem der Ansprüche 24 bis 26, wobei die HF-Antennen kryogen gekühlt werden.

28. Vorrichtung nach einem der Ansprüche 24 bis 27, wobei die HF-Antennen supraleitend sind.

29. Vorrichtung nach einem der Ansprüche 19 bis 28, wenn abhängig von Anspruch 17, wobei eine Schicht aus weichem Ferrit in einer Antennenwindung der Signal-Erregungs-und-Erfassungs-Vorrichtung oder zwischen der Mehrzahl der Antennenleiter und den leitenden Teilen der Vorrichtung angeordnet ist.

30. Vorrichtung nach Anspruch 29, wobei die Ferritschicht aus einer Anzahl von Elementen besteht, um Dimensionsresonanzen zu verhindern.

31. Vorrichtung nach einem der Ansprüche 19 bis 30, wobei die Magnetfeld-Erzeugungseinrichtungen und die Signal-Erregungs-und-Erfassungs-Vorrichtung an einem Träger zur Bewegung zwischen einer ersten und einer zweiten Position relativ zu dem interessierenden Bereich und entsprechend dem ersten bzw. dem zweiten Modus angebracht sind.

32. Vorrichtung nach Anspruch 31, wobei die Magnetfeld-Erzeugungseinrichtungen und die Signal-Erregungs-und-Erfassungs-Vorrichtung an festen Positionen relativ zueinander an dem Träger angebracht sind.

33. Verfahren zum Gewinnen von NMR-Informationen über eine Probe, wobei das Verfahren umfasst:
I) Betreiben einer Magnetfeld-Erzeugungsanordnung, die eine erste und eine zweite Magnetfeld-Erzeugungseinrichtung (7, 8, 13) enthält, so dass beide Magnetfelder in der gleichen Richtung erzeugen, um ein relativ starkes, im Allgemeinen uneinheitliches statisches Magnetfeld in einem Arbeitsvolumen, das sich außerhalb der Anordnung befindet und eine Probe enthält, über eine Zeitdauer anzuwenden, die länger ist als die längste Spin-Gitter-Relaxationszeit (T1) des interessierenden Materials in der Probe, um zuzulassen, dass sich verstärkte Magnetisierung in der Probe aufbaut;
II) Betreiben der ersten und der zweiten Magnetfeld-Erzeugungseinrichtung (7, 8, 13), so dass Magnetfelder in entgegengesetzten Richtungen erzeugt werden, um ein schwächeres, jedoch gleichmäßigeres statisches Magnetfeld über das Arbeitsvolumen anzuwenden, wobei die Änderung des statischen Magnetfeldes in einer Zeit stattfindet, die kürzer ist als die kürzeste Spin-Spin-Relaxationszeit des interessierenden Materials in der Probe, jedoch länger als die Larmor-Periode;
III) Anwenden einer geeigneten Sequenz von Funkfrequenzimpulsen, um NMR-Signale zu erzeugen;
IV) Erfassen und Aufzeichnen der NMR-Signale; und
V) Verarbeiten der aufgezeichneten Daten.

34. Verfahren nach Anspruch 33 zum Messen von Gesamt-NMR-Eigenschaften der Probe, wobei Schritt V) des Weiteren Verarbeiten der aufgezeichneten Daten zum Berechnen von Gesamt-NMR-Eigenschaften umfasst.

35. Verfahren nach Anspruch 33 zum Gewinnen von NMR-Informationen über ein Objekt, wobei Schritt III) des Weiteren Anwenden von Impulsen eines Schalt-Gradienten-Magnetfeldes zum Kodieren der Bildinformationen in den NMR-Signalen umfasst und Schritt V) Verarbeiten der aufgezeichneten Daten umfasst, um ein Bild des Objektes zu erzeugen.

36. Verfahren nach Anspruch 35, wobei das Abbildungsobjekt eine Extremität oder ein anderer lebender Körperteil ist, der Gewebe mit nicht-isotropen NMR-Eigenschaften enthält, so beispielsweise eine Sehne oder ein Band.

37. Verfahren nach Anspruch 36, wobei das nicht-isotrope Gewebe in dem Körperteil in dem "magischen Winkel" zu der Richtung des statischen Feldes ausgerichtet ist.

38. Verfahren nach einem der Ansprüche 35 bis 37, wobei die Position zweidimensionaler tomografischer Bilder ausgewählt wird, indem ein amplitudenmodulierter Umkehr-HF-Impuls während des Übergangs von dem ersten zu dem zweiten Feldzustand angewendet wird.

39. Verfahren nach einem der Ansprüche 33 bis 38, wobei die Magnetfeld-Erzeugungsanordnung nach einem der Ansprüche 1 bis 18 aufgebaut ist.

## Revendications

1. Ensemble générateur de champ magnétique comprenant un système générant un champ magnétique, comprenant un premier et un deuxième générateur de champ magnétique (7, 8, 13) pour générer des champs magnétique statiques, respectifs ; et un système de contrôle, le système générant un champ magnétique étant disposé pour générer, dans un premier mode, un premier champ magnétique statique relativement fort dans un volume de travail placé à l'extérieur de l'ensemble, et pour générer, dans un deuxième mode, un deuxième champ magnétique statique dans le volume de travail, où le système de contrôle est disposé pour contrôler le deuxième générateur de champ magnétique de sorte que dans le premier mode, les deux générateurs de champ magnétique (7, 8, 13) génèrent des champs magnétiques dans le même sens pour générer le premier champ magnétique statique relativement fort dans un volume de travail, et de sorte que dans le deuxième mode, les deux générateurs de champ magnétique (7, 8, 13) génèrent des champs magnétiques en sens opposés de sorte que le champ magnétique résultant dans le volume de travail soit plus faible mais plus uniforme que le champ magnétique relativement fort, pour permettre la réalisation d'un processus de résonance magnétique sur un échantillon dans la région de travail.

2. Ensemble selon la revendication 1, où le deuxième générateur de champ magnétique comprend un électro-aimant (201, 203, 205).

3. Ensemble selon l'une quelconque des revendications précédentes, où le premier générateur de champ magnétique comprend un électro-aimant (202, 204, 206).

4. Ensemble selon les revendications 2 et 3, où les positions et la densité de spires des éléments de bobinage composant les premier et deuxième électro-aimants (201-205) sont choisies de sorte que l'inductance mutuelle entre les premier et deuxième électro-aimants soit proche de zéro.

5. Ensemble selon les revendications 2 et 3 ou la revendication 4, où les deux électro-aimants (201-206) sont sensiblement coplanaires avec des sections de bobinage imbriquées.

6. Ensemble selon l'une quelconque des revendications 2 à 5, où les électro-aimants (201-206) sont refroidis par cryogénie.

7. Ensemble selon la revendication 6, où les électro-aimants (201-206) refroidis sont supraconducteurs.

8. Ensemble selon la revendication 7, où les électro-aimants supraconducteurs sont fabriqués à partir d'un supraconducteur à haute température.

9. Ensemble selon la revendication 8, où l'électro-aimant du deuxième générateur de champ magnétique utilise un fil supraconducteur à haute température, optimalisé pour une vitesse élevée de changement de courant.

10. Ensemble selon la revendication 1, où les premier et deuxième générateurs de champ magnétique comprennent une série d'aimants permanents (7, 8, 13), les aimants étant physiquement déplaçables l'un par rapport à l'autre pour modifier l'intensité et l'uniformité du champ magnétique dans le volume de travail.

11. Ensemble selon la revendication 10, où les premier et deuxième générateurs de champ magnétique consistent en une paire (8a, 9a) d'aimants magnétisés de manière radiale, sensiblement cylindriques, l'un étant localisé dans l'autre, où ladite paire d'aimants magnétisés de manière radiale peuvent être mis en rotation relative.

12. Ensemble selon la revendication 11, où la paire d'aimants est concentrique.

13. Ensemble selon la revendication 10, où les aimants (8, 13) sont disposés l'un à côté de l'autre, au moins un étant déplaçable par rapport à l'autre pour inverser sa direction de magnétisation.

14. Ensemble selon la revendication 1, où les générateurs de champ magnétique comprennent un ou plusieurs aimants principaux (7) et au moins deux aimants d'ajustage (8, 13), au moins un des aimants d'ajustage étant ajustable par rapport à l'autre pour obtenir les premières et deuxième conditions.

15. Ensemble selon la revendication 14, où les aimants principaux (7) sont orientés de sorte que leurs directions de magnétisation s'étendent selon un angle aigu par rapport aux directions de magnétisation des aimants d'ajustage.

16. Ensemble selon l'une quelconque des revendications 10 à 15, comprenant en outre, des moyens pour déplacer les générateurs de champ magnétique, les moyens comprenant l'un parmi un appareil de commande électromagnétique, un appareil de commande hydraulique, un appareil de commande pneumatique, un appareil de commande piézoélectrique ou u un appareil de commande mécanique comme un ressort, des engrenages, des leviers, l'expansion on la contraction thermique et un métal à mémoire.

17. Ensemble selon l'une quelconque des revendications 10 à 16, où les générateurs de champ magnétique (7, 8, 13) sont des aimants permanents en terre rare.

18. Ensemble selon l'une quelconque des revendications précédentes, entouré d'une bobine de blindage commutable, qui est débranchée dans le deuxième mode, mais branchée dans le premier mode, de sorte qu'elle ait un moment magnétique sensiblement égal et opposé au moment magnétique combiné des premier et deuxième générateurs de champ magnétique dans le premier mode.

19. Appareil pour générer une image tomographique à RM d'un sujet, l'appareil consistant en un ensemble générateur de champ magnétique selon l'une quelconque des revendications précédentes, le sujet étant placé dans le volume de travail lors de l'utilisation ; un appareil d'excitation et de détection de signal pour appliquer une impulsion de champ magnétique oscillant à la fréquence de Larmor du noyau du matériau intéressant dans le volume de travail, le champ oscillant étant sensiblement orthogonal au champ magnétique statique, et pour réceptionner les signaux RMN des noyaux excités ; des bobines à gradient pour coder le signal RMN k-space ; et un système pour enregistrer et traiter les signaux en image.

20. Appareil selon la revendication 19, dépendant de la revendication 5, où les bobines à gradient sont des bobines planes montées dans sensiblement le même plan que les électro-aimants.

21. Appareil selon la revendication 19, dépendant de la revendication 5, où les bobines à gradient sont des bobines planes montées dans le plan orthogonal au plan des électro-aimants.

22. Appareil selon l'une quelconque des revendications 19 à 21, comprenant en outre, un système de refroidissement pour refroidir de manière cryogénique les bobines à gradient.

23. Appareil selon l'une quelconque des revendications 19 à 22, où l'appareil d'excitation et de détection de signal comprend une antenne de radiofréquence pour générer des impulsions de champ magnétique oscillant à la fréquence de résonance de Larmor du sujet, de manière orthogonale au champ magnétique statique au cours du deuxième mode ; et une antenne de radiofréquence pour détecter les signaux RMN depuis l'échantillon au cours du deuxième mode.

24. Appareil selon la revendication 23, où les antennes RF comprennent des bobines RF orthogonales.

25. Appareil selon la revendication 23 ou 24, où les antennes comprennent une bobine RF, qui peut être placée sur la surface du sujet lors de l'utilisation.

26. Appareil selon l'une quelconque des revendications 23 à 25, dépendant de la revendication 5, où les antennes comprennent une bobine RF montée dans essentiellement le même plan que les électro-aimants.

27. Appareil selon l'une quelconque des revendications 24 à 26, où les antennes RF sont refroidies de manière cryogénique.

28. Appareil selon l'une quelconque des revendications 24 à 27, où les antennes RF sont supraconductrices.

29. Appareil selon l'une quelconque des revendications 19 à 28, dépendant de la revendication 17, où une couche de ferrite tendre est placée dans un bobinage d'antenne de l'appareil d'excitation et de détection de signal ou entre la majorité des conducteurs d'antenne et des parties conductrices de l'outil.

30. Appareil selon la revendication 29, où la couche de ferrite est constituée d'un certain nombre d'éléments pour prévenir les résonances dimensionnelles.

31. Appareil selon l'une quelconque des revendications 19 à 30, où les générateurs de champ magnétique et l'appareil d'excitation et de détection de signal sont montés sur un support pour le mouvement entre les première et deuxième positions par rapport à la région intéressante et correspondant aux premier et deuxième modes, respectivement.

32. Appareil selon la revendication 31, où les générateurs de champ magnétique et l'appareil d'excitation et de détection de signal sont montés en des emplacements fixes l'un par rapport à l'autre, sur le support.

33. Procédé d'obtention d'une information RMN sur un échantillon, le procédé comprenant :
(i) le fonctionnement d'un ensemble générant un champ magnétique comprenant un premier et un deuxième générateur de champ magnétique (7, 8, 13) de sorte qu'ils génèrent des champs magnétiques dans le même sens pour appliquer un champ magnétique statique relativement fort, généralement non uniforme dans un volume de travail placé à l'extérieur de l'ensemble, et contenant un échantillon, pour une durée supérieure à au plus long temps de relaxation spin-réseau (T1) du matériau intéressant dans l'échantillon pour permettre d'élaboration d'une magnétisation amplifiée dans l'échantillon ;
(ii) le fonctionnement des premier et deuxième générateurs de champ magnétique (7, 8, 13) pour générer, des champs magnétiques en sens opposés pour appliquer un champ magnétique statique plus faible mais beaucoup plus uniforme dans le volume de travail, le changement du champ magnétique statique se produisant en un temps plus court que le temps de relaxation spin-spin (T2) le plus court du matériau d'intérêt dans l'échantillon, mais plus long que la période de Larmor ;
(iii) l'application d'une séquence appropriée d'impulsions de radiofréquence pour générer des signaux RMN ;
(iv) la détection et l'enregistrement des signaux RMN, et
(v) le traitement des données enregistrées.

34. Procédé selon la revendication 33, pour mesurer les propriétés RMN en masse de l'échantillon, où l'étape (v) comprend en outre, le traitement des données enregistrées pour calculer les propriétés RMN en masse.

35. Procédé selon la revendication 33, pour l'obtention d'une information RMN sur un sujet, où l'étape (iii) comprend en outre, l'application d'impulsions commutées de champ magnétique à gradient de manière à encoder l'information d'image dans les signaux RMN, l'étape (v) comprenant le traitement des données enregistrées pour former une image du sujet.

36. Procédé selon la revendication 35, dans lequel le sujet d'imagerie et un membre ou une partie de corps in vivo contenant un tissu avec des propriétés RMN non isotropes, comme un tendon ou un ligament.

37. Procédé selon la revendication 36, dans lequel le tissu non isotrope dans la partie du corps est orienté selon « l'angle magique » par rapport à la direction du champ statique.

38. Procédé selon l'une quelconque des revendications 35 à 37, dans lequel l'emplacement des images tomographiques en deux dimensions est sélectionné en appliquant une impulsion RF d'inversion, modulée sur l'amplitude, pendant la transition entre les premier et deuxième états de champ.

39. Procédé selon l'une quelconque des revendications 33 à 38, dans lequel l'ensemble générant un champ magnétique est construit selon l'une quelconque des revendications 1 à 18.
